# EUROPEAN PATENT SPECIFICATION

(11) **EP 1 621 339 B1**
(45) Date of publication and mention of the grant of the patent: **10.09.2008**
(21) Application number: 05016620.6
(22) Date of filing: 29.07.2005
(51) Int. Cl.: B41C 1/10, G03F 7/32

(54) **Plate-making method of lithographic printing plate**
Verfahren zur Herstellung lithographischer Druckplatten
Procédé pour la fabrication des plaques lithographiques

(30) Priority: 29.07.2004 JP 2004221499
(43) Date of publication of application: 01.02.2006
(73) Proprietor: FUJIFILM Corporation, Minato-ku Tokyo (JP)
(72) Inventor: Nagase, Hiroyuki, Haibara-gun Shizuoka (JP)
(74) Representative: HOFFMANN EITLE

(56) References cited:
- EP-A- 0 080 042
- EP-A- 0 602 739
- EP-A- 1 513 020
- US-A- 4 147 545
- US-A- 4 395 480
- US-A- 4 786 582
- US-A- 4 851 324
- US-A- 5 035 982
- US-B1- 6 649 324
- DATABASE WPI Week 197909 Derwent Publications Ltd., London, GB; AN 1979-16716B XP002351993 & JP 54 008002 A (FUJI PHOTO FILM CO LTD) 22 January 1979 (1979-01-22)
- DATABASE WPI Week 198925 Derwent Publications Ltd., London, GB; AN 1989-012543 XP002351994 & JP 63 289546 A (FUJI PHOTO FILM CO., LTD) 28 November 1988 (1988-11-28)

## Description

### 1. Field of the Invention

The present invention relates to a plate-making method of a lithographic printing plate which can be developed in the region from acidic to low alkaline.

### 2. Description of the Related Art

The lithographic printing plate in general consists of a lipophilic image area of receiving an ink in the printing process and a hydrophilic non-image area of receiving a fountain solution. The lithographic printing is a printing method utilizing the repellency between water and printing ink from each other, where the lipophilic image area of the lithographic printing plate and the hydrophilic non-image area are formed as an ink-receiving part and a fountain solution-receiving part (ink non-receiving part), respectively, to cause difference in the ink adhesion on the surface of the lithographic printing plate, an ink is attached only to the image area and thereafter, the ink is transferred to a material on which the image is printed, such as paper, thereby performing printing.

For producing this lithographic printing plate, a lithographic printing plate precursor (PS plate) comprising a hydrophilic support having provided thereon a lipophilic photosensitive resin layer (image-recording layer) has been heretofore widely used. Usually, a lithographic printing plate is obtained by a plate-making method where the lithographic printing plate precursor is exposed through an original image such as lith film and while leaving the image-recording layer in the image area, the other unnecessary image-recording layer is dissolved and removed with an alkaline developer or an organic solvent to reveal the hydrophilic support surface, thereby forming a non-image area.

In the plate-making process using a conventional lithographic printing plate precursor, a step of dissolving and removing the unnecessary image recording layer with a developer or the like must be provided after exposure but in view of environmental concern and safety, processing with a developer closer to a neutral region or reduction of waste solution is requested as a problem to be solved. Particularly, the treatment of waste solution discharged accompanying the wet processing is recently a great concern to the entire industry in view of consideration for global environment, and the demand for solving the above-described problems is becoming stronger.

On the other hand, a digitization technique of electronically processing, storing and outputting image information by using a computer has been recently widespread and various new image-outputting systems coping with such a digitization technique have been put into practical use. Along with this, a computer-to-plate (CTP) technique is attracting attention, where digitized image information is carried on a highly converging radiant ray such as laser ray and a lithographic printing plate precursor is scan-exposed by this ray with no intervention of a lith film to directly produce a lithographic printing plate. Accordingly, one of important technical problems to be solved is to obtain a lithographic printing plate precursor suitable for such a technique.

In this way, the demand for reduction in alkalinity of developer and simplification of processing step is ever-stronger from both aspects of consideration for global environment and adaptation for small space and low running cost. However, as described above, the development processing generally consists of three steps of developing a lithographic printing plate precursor with an aqueous alkali solution at a pH of 10 or more, washing the alkali agent in a water-washing bath, and treating the plate with a gum solution mainly comprising a hydrophilic resin. Therefore, the automatic developing machine itself takes a large space and furthermore, problems in view of environmental issue and running cost are remaining, such as treatment of development waste, water washing waste and gum solution waste.

In order to solve these problems, for example, JP-A-2002-91016 proposes a developing method using an alkali solution containing a nonionic surfactant at a pH of 10 to 12.5, but this method has a problem that development fails at a pH lower than the prescribed range because the photosensitive composition contains an alkali-soluble polymer. Also, for example, Japanese Patent No. 2,938,397 describes a lithographic printing plate precursor comprising a hydrophilic support having provided thereon an image-forming layer comprising hydrophobic thermoplastic polymer particles dispersed in a hydrophilic binder. This lithographic printing plate precursor can be, after forming an image by causing the hydrophobic thermoplastic polymer particles to coalesce due to heat upon image-exposure with an infrared laser, loaded on a cylinder of a printing press and then on-press developed with a fountain solution and/or an ink.

Such a method of forming an image through coalescence of fine particles by mere heat fusion exhibits good on-press developability but has a problem that the image strength (adhesion to the support) is very weak and the press life is insufficient.

### Summary of the Invention

As described above, the development system using an alkali agent has an environmental problem, requires to provide a replenisher and an apparatus for compensating the reduction of pH due to absorption of carbonic acid gas, which is associated with a problem such as increase of the waste solution, and is disadvantageous in view of running cost of developer. An object of the present invention is to solve these problems by providing a method of enabling the development in the region from acidic to neutral.

As a result of intensive investigations to achieve the above-described object, the present inventors have found that a lithographic printing plate precursor not having an alkali-soluble acid group can be developed by contacting it with a specific aqueous solution after image exposure and those problems can be thereby solved. The present invention has been accomplished based on this finding.

That is, the present invention is as described in the appending claims.

### Brief Description of the Drawing

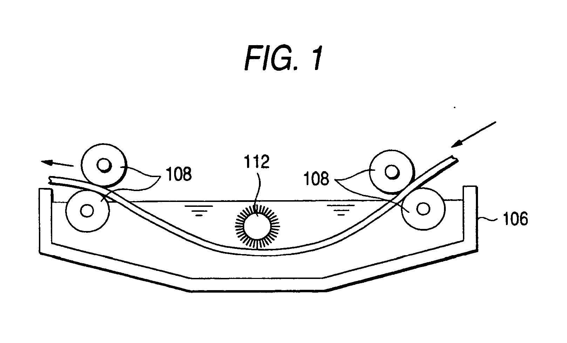

Fig. 1 is a schematic view of developing machine.

106 denotes a development tank, 108 denotes a transportation roller, and 112 denotes a rotary brush.

### Detailed Description of the Invention

### [Developer (Processing Solution)]

As for the anionic and nonionic surfactants for use in the processing solution of the present invention, the followings can be used.

Examples of the anionic surfactant include fatty acid salts, abietates, hydroxyalkanesulfonates, alkanesulfonates, dialkylsulfosuccinates, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated castor oils, sulfated beef tallow oils, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified products of styrene/maleic anhydride copolymer, partially saponified products of olefin/maleic anhydride copolymer, and naphthalenesulfonate formalin condensates.

The anionic surfactant is preferably a compound represented by formula (I) or (II):

R₁-SO₃⁻ (I)

R₂-O-SO₃⁻ (II)

wherein R₁ and R₂ each represents an alkyl, cycloalkyl, alkenyl, aralkyl or aryl group which may have a substituent. The alkyl group is, for example, an alkyl group having from I to 20 carbon atoms and specific preferred examples thereof include a methyl group, an ethyl group, a propyl group, an n-butyl group, a sec-butyl group, a hexyl group, a 2-ethylhexyl group, an octyl group, a decyl group, a dodecyl group, a hexadecyl group and a stearyl group.

The cycloalkyl group may be a monocyclic type or a polycyclic type. The monocyclic type is a cycloalkyl group having from 3 to 8 carbon atoms and preferred examples thereof include a cyclopropyl group, a cyclopentyl group, a cyclohexyl group and a cyclooctyl group. Preferred examples of the polycyclic type include an adamantyl group, a norbornyl group, an isoboronyl group, a camphonyl group, a dicyclopentyl group, an α-pinel group and a tricyclodecanyl group.

The alkenyl group is, for example, an alkenyl group having from 2 to 20 carbon atoms and specific preferred examples thereof include a vinyl group, an allyl group, a butenyl group and a cyclohexenyl group.

The aralkyl group is, for example, an aralkyl group having from 7 to 12 carbon atoms and specific preferred examples thereof include a benzyl group, a phenethyl group and a naphthylmethyl group.

The aryl group is, for example, an aryl group having from 6 to 15 carbon atoms and specitic preferred examples thereof include a phenyl group, a tolyl group, a dimethylphenyl group, a 2,4,6-trimethylphenyl group, a naphthyl group, an anthryl group and a 9,10-dimethoxyanthryl group.

As for the substituent, a monovalent nonmetallic atom group excluding a hydrogen atom is used and preferred examples thereof include a halogen atom (e.g., F, Br, Cl, I), a hydroxyl group, an alkoxy group, an aryloxy group, an acyl group, an amido group, an ester group, an acyloxy group, a carboxy group, a carboxylate anion group and a sulfonate anion group.

In these substituents, specific examples of the alkoxy group include those having from 1 to 40 carbon atoms, preferably from 1 to 20 carbon atoms, such as methoxy group, ethoxy group, propyloxy group, isopropyloxy group, butyloxy group, pentyloxy group, hexyloxy group, dodecyloxy group, stearyloxy group, methoxyethoxy group, poly(ethyleneoxy) and poly(propyleneoxy); specific examples of the aryloxy group include those having from 6 to 18 carbon atoms, such as phenoxy group, tolyloxy group, xylyloxy group, methyloxy group, cumenyloxy group, methoxyphenyloxy group, ethoxyphenyloxy group, chlorophenyloxy group, bromophenyloxy group and naphthyloxy group; specific examples of the acyl group include those having from 2 to 24 carbon atoms, such as acetyl group, propanoyl group, butanoyl group, benzoyl group and naphthoyl group; specific examples of the amido group include those having from 2 to 24 carbon atoms, such as acetamido group, propionic acid amido group, dodecanoic acid amide group, palmitic acid amide group, stearic acid amide group, benzoic acid amide group and naphthoic acid amide group; specific examples of the acyloxy group include those having from 2 to 20 carbon atoms, such as acetoxy group, propanoyloxy group, benzoyloxy group and naphthoyloxy group; and specific examples of the ester group include those having from 1 to 24 carbon atoms, such as methyl ester group, ethyl ester group, propyl ester group, hexyl ester group, octyl ester group, dodecyl ester group and stearyl ester group. The substituent may be a substituent comprising a combination of two or more of these substituents.

Among the compounds represented by formulae (I) and (II), preferred in view of the effect of the present invention are the compounds represented by the following formulae (I-A) and (I-B): 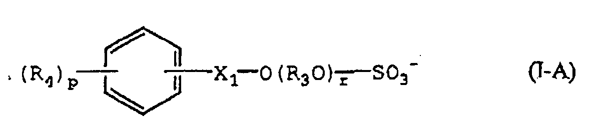 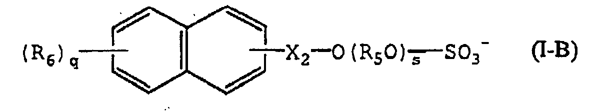 (wherein R₃ and R₅ each represents a linear or branched alkylene group having from 1 to 5 carbon atoms; R₄ and R₆ each represents a linear or branched alkylene group having from 1 to 20 carbon atoms; p and q each represents 0, 1 or 2; X₁ and X₂ each represents a single bond or an alkylene group having from 1 to 10 carbon atoms; and and s each represents an integer of 1 to 100, provided that when r and s each is 2 or more, two or more groups may be selected for each of R₃ and R₅).

Examples of the compounds represented by formulae (I) and (II) are set forth below, but the present invention is not limited thereto.

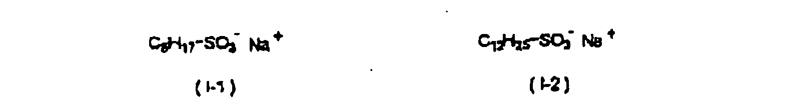

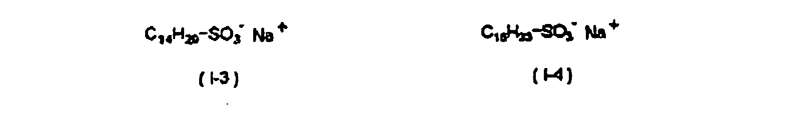

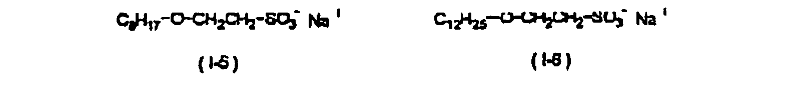

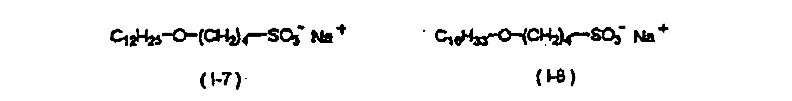

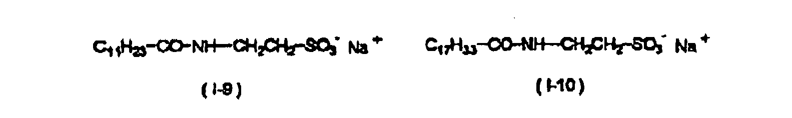

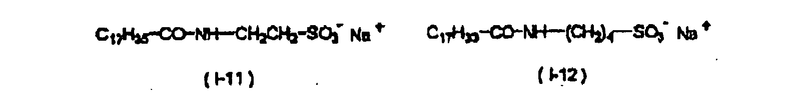

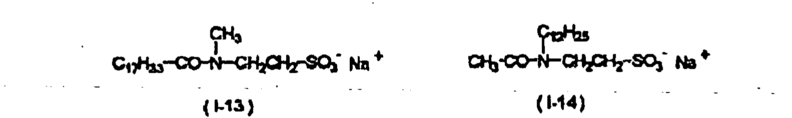

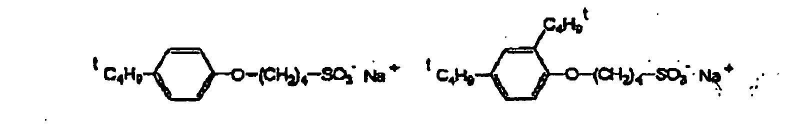

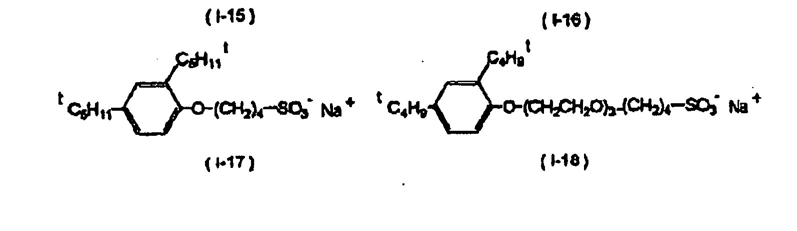

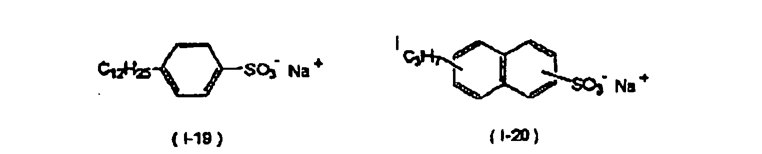

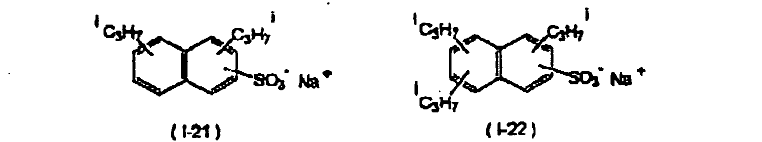

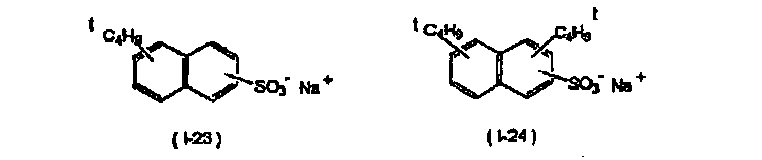

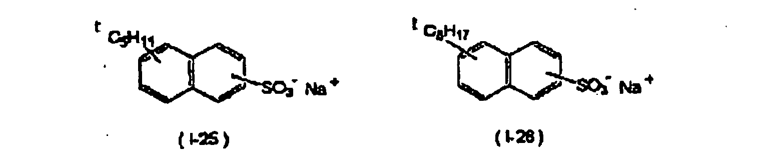

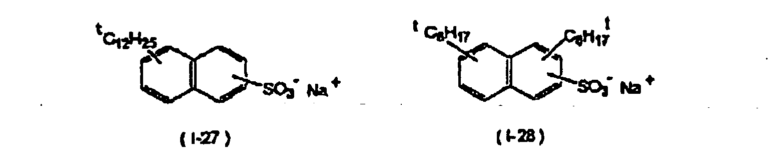

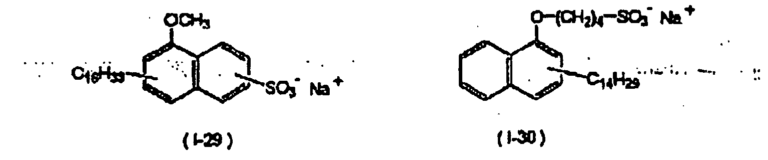

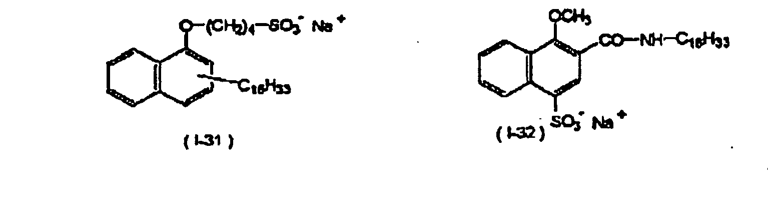

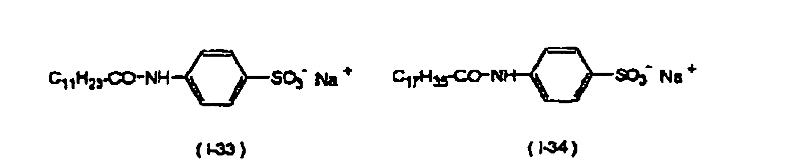

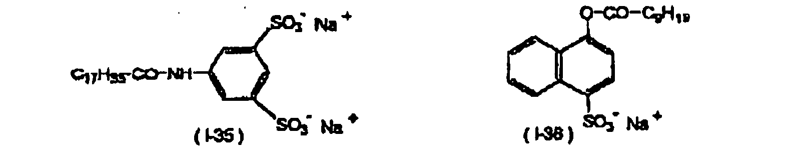

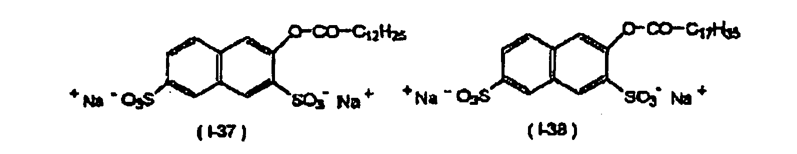

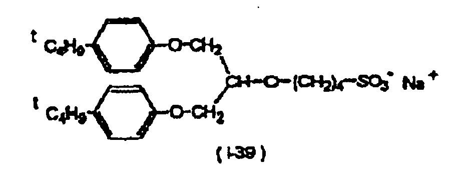

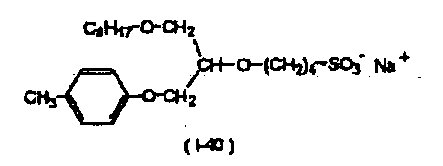

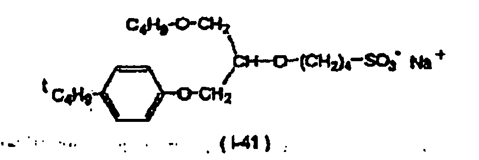

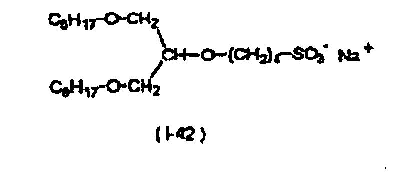

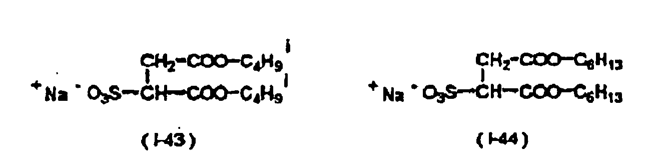

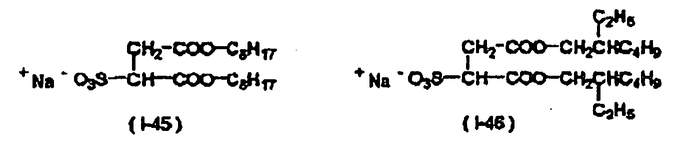

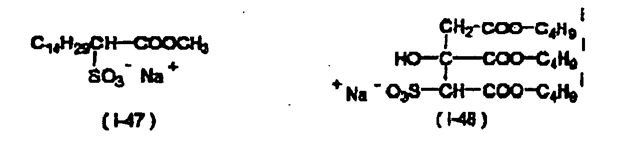

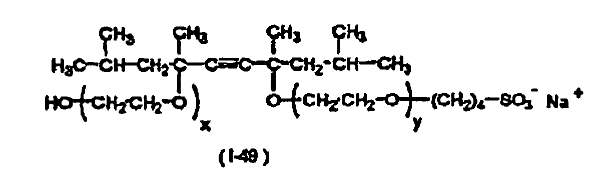

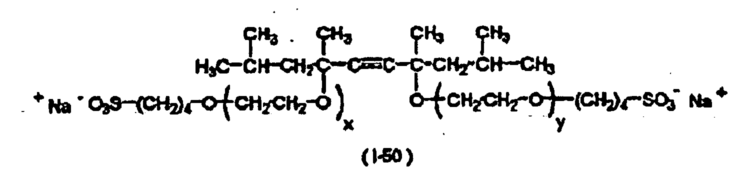

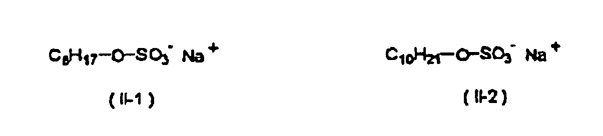

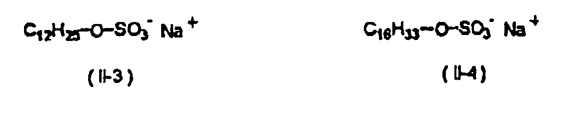

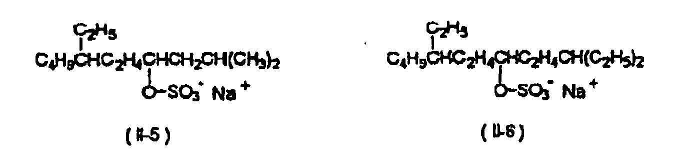

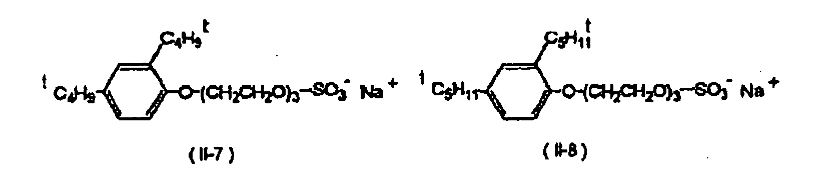

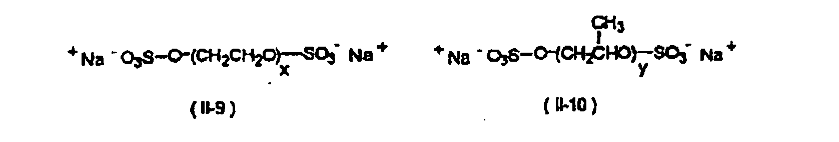

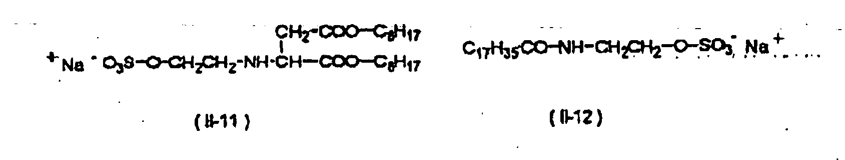

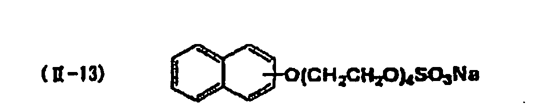

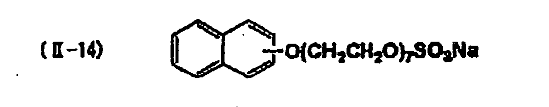

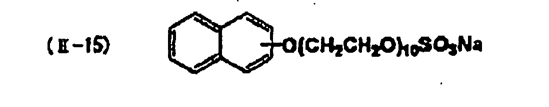

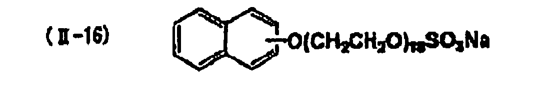

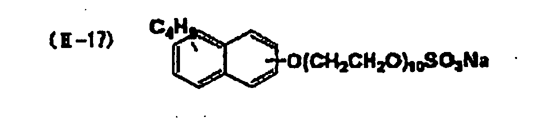

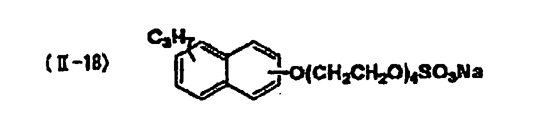

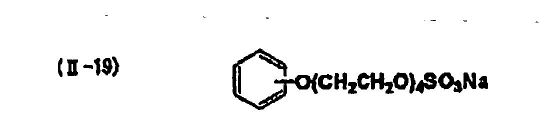

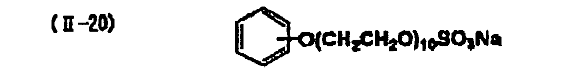

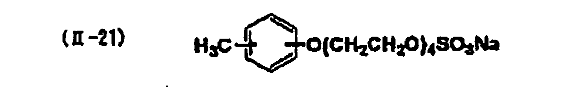

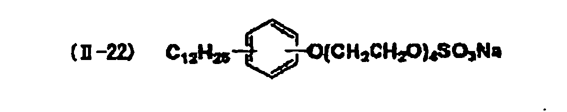

In these specific examples, x and y each represents a repeating number of the ethyleneoxy or propyleneoxy chain and each represents an integer of 1 to 20 (on average).

The amount of the compound represented by formula (I) or (II) added in the developer is suitably from 1 to 10 mass%, preferably from 2 to 10 mass%. When the amount of the compound added is in this range, the developing property, the solubility of photosensitive layer components, and the press life of printing plate are satisfied.

The compounds represented by formulae (I) and (II) are commonly available on the market. Examples of the commercially available product include those produced by Asahi Denka Co., Ltd., Kao Corp., Sanyo Chemical Industries Co., Ltd., New Japan Chemical Co., Ltd., Dai-ichi Kogyo Seiyaku Co., Ltd., Takemoto Oil & Fat Co., Ltd., Toho Chemical Industrial Co., Ltd. and NOF Corporation.

Examples of the nonionic surfactant include polyoxyethylene alkyl ethers, polyoxyethylene alkylphenyl ethers, polyoxyethylene polystyrylphenyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylene glycerin fatty acid partial esters, polyoxyethylene diglycerins, fatty acid diethanolamides, N,N-bis-2-hydroxyalkylamines, polyoxyethylene alkylamines, triethanolamine fatty acid esters, trialkylamine oxides, polyoxyethylene alkylphenyl ethers and polyoxyethylene-polyoxypropylene block copolymers.

Furthermore, for example, acetylene glycol-based or acetylene alcohol-based oxyethylene adducts, and fluorine-containing or silicon-containing anionic or nonionic surfactants may also be used. These surfactants can be used in combination of two or more thereof. For example, a combination of two or more anionic surfactants different from each other, or a combination of an anionic surfactant and a nonionic surfactant is preferred. From these compounds, an appropriate compound is preferably selected by taking account of the effect on the environment and used. The amount of surfactant used is 1 mass % or more of either both of a nonionic and an anionic surfactant. (anionic surfactant component)

The nonionic surfactant is in particular preferably a nonionic aromatic ether-based surfactant represented by the following formula (1):

X-Y-O-(A)ₙ-(B)ₘ-H (1)

(wherein X represents an aromatic group which may have a substituent, Y represents a single bond or an alkylene group having from 1 to 10 carbon atoms, A and B are different from each other and each represents either -CH₂CH₂O- or -CH₂CH(CH₃)O-, and n and m each represents 0 or an integer of 1 to 100, provided that n and m are not 0 at the same time and that when either n or m is 0, n and m are not 1).

Examples of the aromatic group of X include a phenyl group, a naphthyl group and an anthranyl group. These aromatic groups each may have a substituent. Examples of the substituent include an organic group having from 1 to 100 carbon atoms. Examples of the organic group include all organic groups described regarding the following formulae (1-A) and (1-B). In the formula above, when A and B both are present, the compound may be either a random copolymer or a block copolymer.

The compound specifically includes those represented by the following formulae (1-A) and (1-B). 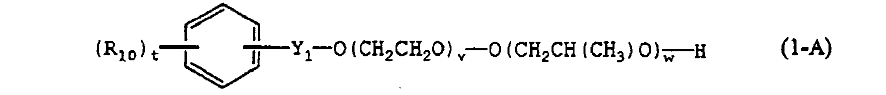 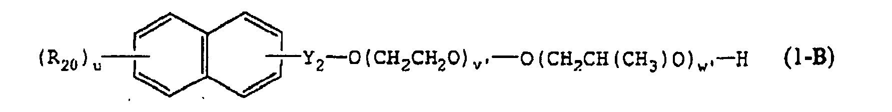 (wherein R₁₀ and R₂₀ each represents a hydrogen atom or an organic group having from 1 to 100 carbon atoms; t and u each represents 1 or 2; Y₁ and Y₂ each represents a single bond o an alkylene group having from 1 to 10 carbon atoms; v and w each represents 0 or an integer of 1 to 100, provided that v and w are not 0 at the same time and that when either v or w is 0, v and w are not 1; and v' and w' each represents 0 or an integer of 1 to 100, provided that v' and w' are not 0 at the same time and that when either v' or w' is 0, v' and w' are not 1).

When t represents 2 and R₁₀ is an organic group having from 1 to 100 carbon atoms, R₁s may be the same or different and R₁₀s may combine to constitute a ring, and when u represents 2 and R₂₀ is an organic group having from 1 to 100 carbon atoms, R₂₀s may be the same or different and R₂₀s may combine to constitute a ring.

Specific examples of the organic group having from 1 to 100 carbon atoms include aliphatic hydrocarbon groups and aromatic hydrocarbon groups, which may be saturated or unsaturated and may be linear or branched, such as alkyl group, alkenyl group, alkynyl group, aryl group and aralkyl group. Other examples include an alkoxy group, an aryloxy group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an acylamino group, an N-alkylacylamino group, an N-arylacylamino group, an acyl group, an alkoxycarbonylamino group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, a polyoxyalkylene chain, and these organic groups bonded with a polyoxyalkylene chain. The above-described alkyl group may be linear or branched.

R₁₀ and R₂₀ each is preferably, for example, a hydrogen atom, a linear or branched alkyl group having from 1 to 10 carbon atoms, an alkoxy group having from 1 to 10 carbon atoms, an alkoxycarbonyl group, an N-alkylamino group, an N,N-dialkylamino group, an N-alkylcarbamoyl group, an acyloxy group, an acylamino group, a polyoxyalkylene chain having a repeating unit number of approximately from 5 to 20, an aryl group having from 6 to 20 carbon atoms, or an aryl group bonded with a polyoxyalkylene chain having a repeating unit number of approximately from 5 to 20.

In the compounds of formulae (1-A) and (1-B), the number of polyoxyethylene chain repeating units is preferably from 3 to 50, more preferably from 5 to 30, and the number of polyoxypropylene chain repeating units is preferably from 0 to 10, more preferably from 0 to 5. The polyoxyethylene moiety and the polyoxypropylene moiety each may be a random or block copolymer.

Examples of the compound represented by formula (1-A) include polyoxyethylene phenyl ether, polyoxyethylene methylphenyl ether, polyoxyethylene octylphenyl ether and polyoxyethylene nonylphenyl ether.

Examples of the compound represented by formula (1-B) include polyoxyethylene naphthyl ether, polyoxyethylene methylnaphthyl ether, polyoxyethylene octylnaphthyl ether and polyoxyethylene nonylnaphtbyl ether.

In the developer, one nonionic aromatic ether-based activator may be used alone, or two or more nonionic aromatic ether-based activators may be used in combination.

The content of the nonionic surfactant such as the above-described nonionic aromatic ether-based activator in the developer is preferably from 1 to 20 mass%, more preferably from 2 to 10 mass%. When the amount of the nonionic surfactant added is in this range, the developing property, the solubility of photosensitive layer components, and the press life of printing plate are satisfied.

Examples of the nonionic aromatic ether-based activators represented by formulae (1-A) and (1-B) are set forth below.

### [Examples of Compound of Formula (I)]

| A-W |
|---|
| 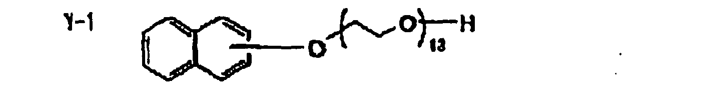 |
| 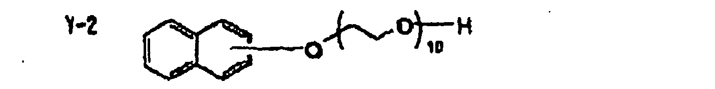 |
| 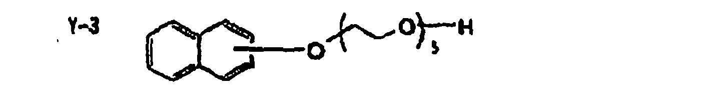 |
| 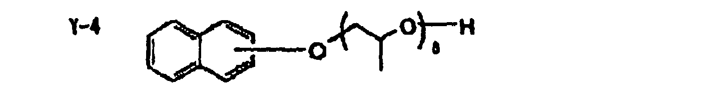 |
| 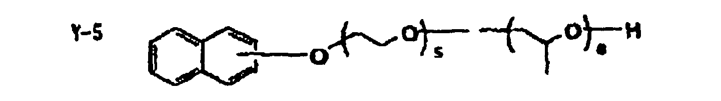 |
| 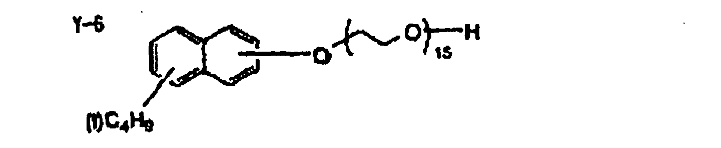 |
| 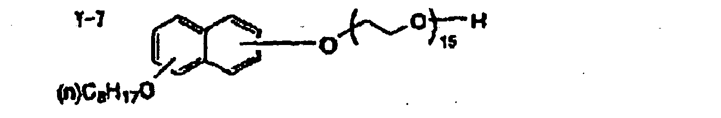 |
| 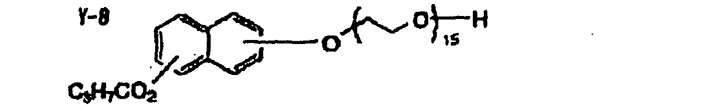 |
| 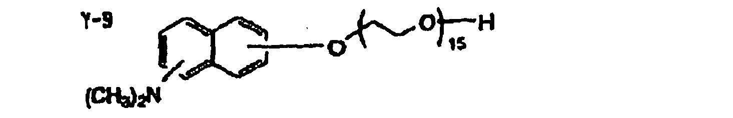 |
| 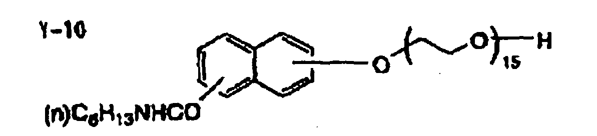 |
| 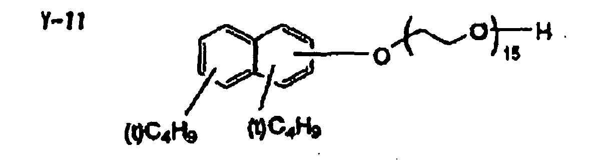 |
| 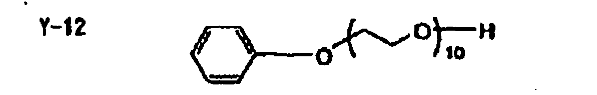 |
| 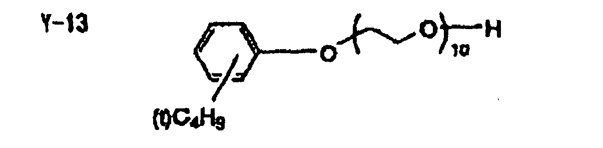 |
| 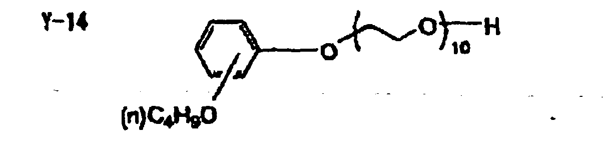 |
| 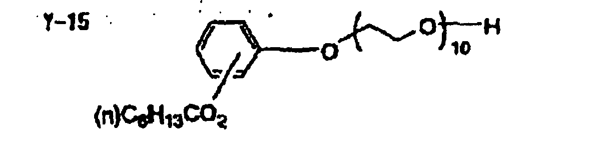 |
| 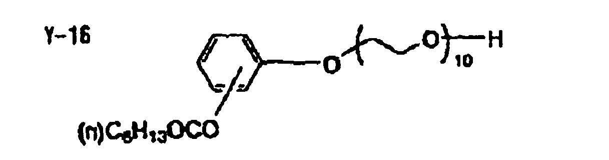 |
| 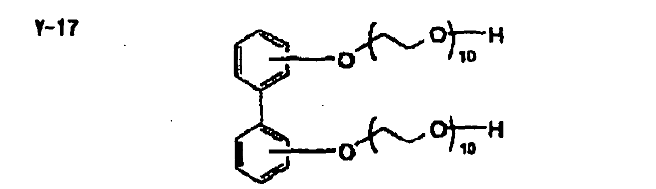 |
| 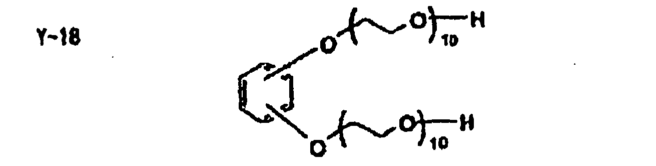 |
| 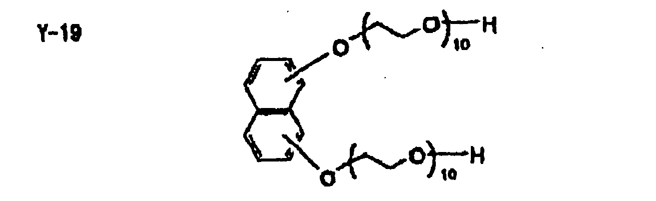 |
| 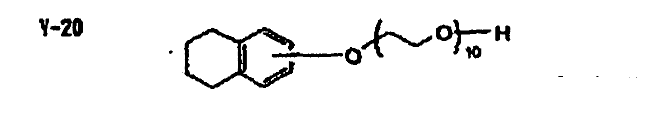 |
| 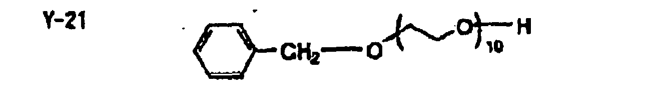 |
| 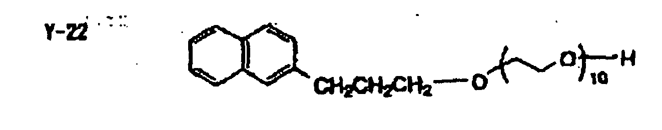 |

The processing solution for use in the present invention contains a water-soluble polymer compound in addition to those surfactants.

Examples of the water-soluble polymer compound used include soybean polysaccharides, denatured starch, gum arabic, dextrin, cellulose derivatives (e.g., carboxymethyl cellulose, carboxyethyl cellulose, methyl cellulose) and denatured products thereof, pullulan, polyvinyl alcohol and derivatives thereof, polyvinylpyrrolidone, polyacrylamide and acrylamide copolymers, vinyl methyl ether/maleic anhydride copolymers, vinyl acetate/maleic anhydride copolymers, and styrene/maleic anhydride copolymers.

As for the soybean polysaccharides, conventionally known compounds can be used. For example, Soyafive (trade name, produced by Fuji Oil Co., Ltd.) is commercially available and those in various grades can be used, but a product of giving an aqueous 10 mass% solution having a viscosity of 10 to 100 mPa/sec is preferred.

The denatured starch is preferably a denatured starch represented by the following formula (I). As for the starch represented by formula (I), starches such as corn, potato, tapioca, rice and wheat all can be used. Such a starch can be denatured, for example, by a method of decomposing the starch with an acid, an enzyme or the like in the range of a glucose residue number of 5 to 30 per molecule and further adding an oxypropylene in an alkali. 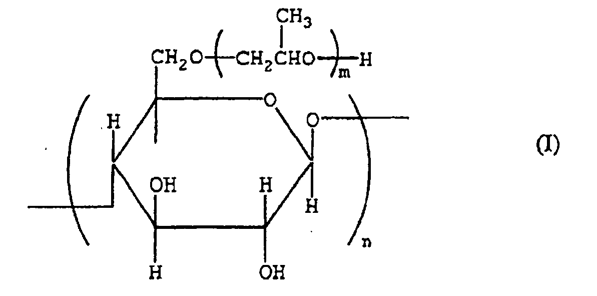 (wherein the etherification degree (substitution degree) is from 0.05 to 1.2 per glucose unit, n represents an integer of 3 to 30, and m represents an integer of 1 to 3).

Among these water-soluble polymer compounds, particularly preferred are soybean polysaccharides, denatured starch, gum arabic, dextrin, carboxymethyl cellulose and polyvinyl alcohol.

The water-soluble polymer compounds can be used in combination of two or more thereof. The content of the water-soluble polymer compound in the processing solution is preferably from 0.1 to 20 mass%, more preferably from 0.5 to 10 mass%.

In the present invention, the water-soluble polymer compound may be used by incorporating it into a processing solution containing the above-described nonionic or anionic surfactant and having a specific pH, or by bringing the lithographic printing plate precursor after development with the processing solution into contact with an aqueous solution containing the water-soluble polymer compound.

In addition to these components, the processing solution for use in the present invention may contain a wetting agent, an antiseptic, a chelating compound, a defoaming agent, an organic acid, an organic solvent, an inorganic acid, an inorganic salt and the like.

Examples of the wetting agent which can be suitably used include ethylene glycol, propylene glycol, triethylene glycol, butylene glycol, hexylene glycol, diethylene glycol, dipropylene glycol, glycerin, trimethylolpropane and diglycerol. These wetting agents may be used either individually or in combination of two or more thereof In general, the wetting agent is used in an amount of 0.1 to 5 mass% based on the entire mass of the processing solution.

Examples of the antiseptic which can be preferably used include phenol and derivatives thereof, formalin, imidazole derivatives, sodium dehydroacetate, 4-isothiazolin-3-one derivatives, benzisothiazolin-3-one, benzotriazole derivatives, amidine guanidine derivatives, quaternary ammonium salts, derivatives of pyridine, quinoline or guanidine, derivatives of diazine or triazole, derivatives of oxazole or oxazine, and nitrobromoalcohol-based antiseptics such as 2-bromo-2-nitropropane-1,3-diol, 1,1-dibromo-1-nitro-2-ethanol and 1, 1-dibromo-1-nitro-2-propanol.

The antiseptic is preferably added in an amount sufficiently large to stably exert the effect against bacteria, fungi, yeast or the like. The amount added varies depending on the kind of bacteria, fungi or yeast, but it is preferably from 0.01 to 4 mass% based on the processing solution in use. Two or more antiseptics are preferably used in combination so as to exert the effect against various fungi or bacteria.

Examples of the chelating compound include organic phosphonic acids and phosphonoalkanetricarboxylic acids, such as ethylenediaminetetraacetic acid, and potassium and sodium salts thereof; diethylenetriaminepentaacetic acid, and potassium and sodium salts thereof; triethylenetetraminehexaacetic acid, and potassium and sodium salts thereof; hydroxyethylethylenediaminetriacetic acid, and potassium and sodium salts thereof; nitrilotriacetic acid and a sodium salt thereof; 1-hydroxyethane-1,1-diphosphonic acid, and potassium and sodium salts thereof; and aminotri(methylenephosphonic acid), and potassium and sodium salts thereof. In place of the sodium or potassium salt of the chelating agent, an organic amine salt may also be effectively used. From these compounds, a chelating agent which can be stably present in the processing solution composition and does not inhibit the printing property, is selected. The amount of the chelating compound added is suitably from 0.001 to 1.0 mass% based on the processing solution in use.

As for the defoaming agent, a silicon-based self-emulsifying or emulsifying surfactant in general or a nonionic compound having an HLB of 5 or less may be used. A silicon defoaming agent is preferred and this defoaming agent may be any type such as emulsion-dispersing type and solubilizing type.

The content of the defoaming agent is suitably from 0.001 to 1.0 mass% based on the processing solution in use.

Examples of the organic acid include a citric acid, an acetic acid, an oxalic acid, a malonic acid, a caprylic acid, a tartaric acid, a malic acid, a lactic acid, a levulinic acid, a p-toluenesulfonic acid, a xylenesulfonic acid, a phytic acid and an organic phosphonic acid. The organic acid may be used in the form of its alkali metal salt or ammonium salt. The content of the organic acid is preferably from 0.01 to 0.5 mass% based on the entire mass of the processing solution.

Examples of the organic solvent which can be used include aliphatic hydrocarbons (e.g., hexane, heptane, "Isopar E, H, G" (produced by Esso Chemical K.K.), gasoline, kerosine), aromatic hydrocarbons (e.g., toluene, xylene), halogenated hydrocarbons (e.g., methylene dichloride, ethylene chloride, trichlene, monochlorobenzene), and polar solvents.

Examples of the polar solvent include alcohols (e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol), ketones (e.g., acetone, methyl ethyl ketone, ethyl butyl ketone, methyl isobutyl ketone, cyclohexanone), esters (e.g., ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate), and others (e.g., triethyl phosphate, tricresyl phosphate, N-phenylethanolamine, N-phenyldiethanolamine).

Also, the organic solvent may be used, when insoluble in water, after solubilizing it in water by using a surfactant or the like. In the case where the developer contains the organic solvent, the concentration of the solvent is preferably less than 40 mass% from the aspect of safety and inflammability.

Examples of the inorganic acid and inorganic salt include phosphoric acid, metaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium bisulfate and nickel sulfate. The content of the inorganic salt is preferably from 0.01 to 0.5 mass% based on the entire mass of the processing solution.

The processing solution for use in the present invention is obtained by dissolving or dispersing these components in water as needed. The solid content concentration of the processing agent is preferably from 1 to 20 mass%. It is also possible to prepare a concentrated solution and dilute it with water when used.

This processing agent can be contacted with the lithographic printing plate for use in the present invention by a method such as manual treatment, dipping treatment or mechanical treatment.

In the case of manual treatment, for example, a method of fully impregnating the aqueous solution into a sponge or an absorbent cotton, treating the lithographic printing plate precursor by rubbing the entire plate surface with the sponge or absorbent cotton, and thoroughly water-washing the plate after the completion of treatment may be used. In the case of dipping treatment, for example, a method of dipping the lithographic printing plate precursor in a vat or deep tank containing the aqueous solution for about 60 seconds with stirring, and then thoroughly water-washing the plate while rubbing it with an absorbent cotton or a sponge may be used.

For the mechanical treatment, a conventionally known gum coater or automatic developing machine for PS plates and CTP plates can be used. In the case of using an automatic developing machine, for example, a system of pumping up the processing solution charged into the developing tank, and spraying the processing solution from a spray nozzle, thereby effecting the treatment; a system of dipping and transporting the printing plate in a tank filled with a processing solution by in-liquid guide rolls, thereby effecting the treatment; and a so-called disposable treatment system of supplying a substantially unused processing solution in a necessary amount every one plate, thereby effecting the treatment, all may be applied. In any system, those having a rubbing mechanism using a brush, a molton or the like are preferred. Furthermore, an apparatus where the laser exposure part and the automatic developing machine portion are integrally incorporated may also be used.

In advance of the above-described development processing, the lithographic printing plate precursor is imagewise exposed by the exposure through a transparent original having a line image, a halftone image or the like, or by the scanning of laser light based on digital data. Examples of the light source suitable for the exposure include a carbon arc lamp, a mercury lamp, a xenon lamp, a metal halide lamp, a strobe, an ultraviolet ray, an infrared ray and a laser beam. In particular, a laser beam is preferred. Examples of the laser include a solid or semiconductor laser of emitting infrared ray at 760 to 1,200 nm, an ultraviolet semiconductor laser of emitting light at 250 to 420 nm, an argon ion laser of emitting visible light, and an FD-YAG laser. Among these, in view of simplification of plate-making, lasers of emitting an infrared or ultraviolet ray to allow for working under white light or yellow light are preferred.

In the present invention, the lithographic printing plate precursor processed with the processing agent is preferably dried so as to facilitate the subsequent handling. Examples of the drying method include natural drying of leaving the lithographic printing plate to stand in a room, hot-air drying, and a method using a drier attached to the cum coater or automatic developing machine.

### [Lithographic Printing Plate Precursor]

The lithographic printing plate precursor for use in the present invention comprises a support having thereon a negative image recording layer curable by exposure and removable by a printing ink, a fountain solution or both thereof. In the light of ensuring easy developability and good printing press, the negative image recording layer is a polymerizable image recording layer containing (1) a polymerization initiator, (2) a polymerizable compound and (3) a hydrophobic binder polymer as essential components. The constituent elements and components of the lithographic printing plate precursor, such as image recording layer and support, are described below.

### (Image Recording Layer)

### <Polymerization Initiator>

The polymerization initiator for use in the present invention is a compound of generating a radical or an acid by the effect of light or heat energy and thereby initiating or accelerating the polymerization of a compound having a polymerizable unsaturated group. Such a polymerization initiator may be appropriately selected and used from known radical or acid generators, compounds having a bond with small bond-dissociation energy, and the like.

Examples of the compound of generating a radical or an acid include organohalogen compounds, carbonyl compounds, organic peroxides, azo-based compounds, azide compounds, metallocene compounds, hexaarylbiimidazole compounds, organic boron compounds, disulfone compounds, oxime ester compounds and onium salt compounds.

Specific examples of the organohalogen compound include the compounds described in Wakabayashi et al., Bull. Chem. Soc. Japan, 42, 2924 (1969), U.S. Patent 3,905,815, JP-B-46-4605 (the term "JP-B" as used herein means an "examined Japanese patent publication"), JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, M.P. Hutt, Journal of Heterocyclic Chemistry, 1, No. 3 (1970). In particular, oxazole compounds substituted with a trihalomethyl group and S-triazine compounds are preferred.

Furthermore, s-triazine or oxadiazole derivatives having at least one mono-, di- or tri-halogenated methyl group bonded to the s-triazine or oxadiazole ring are more preferred and specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

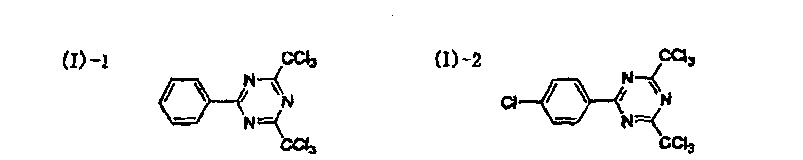

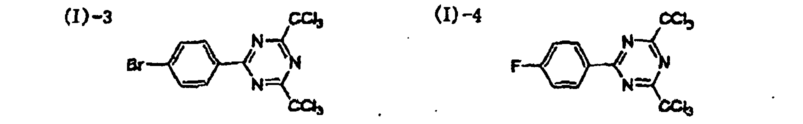

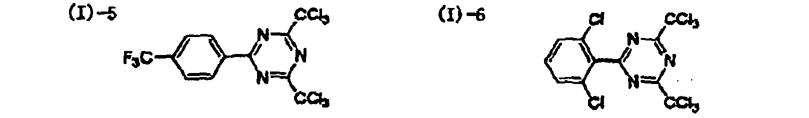

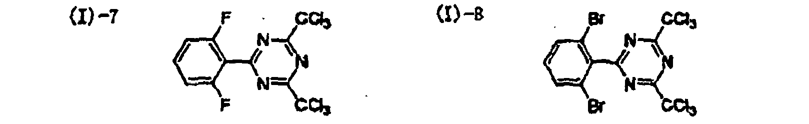

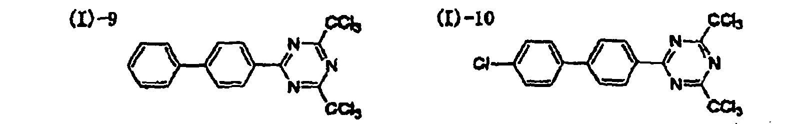

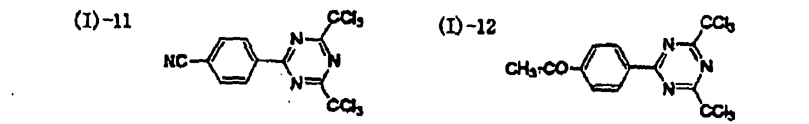

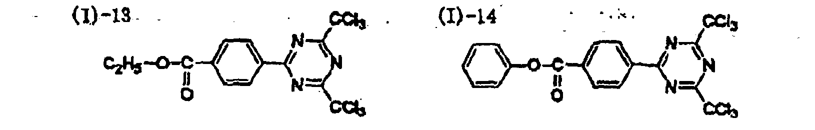

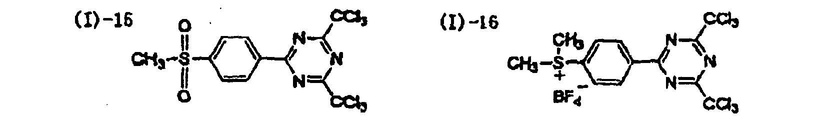

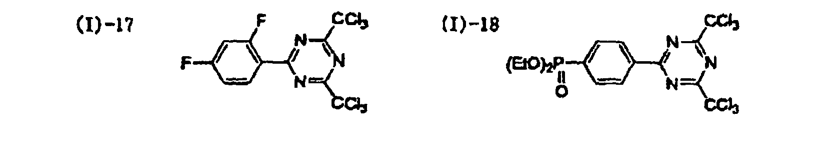

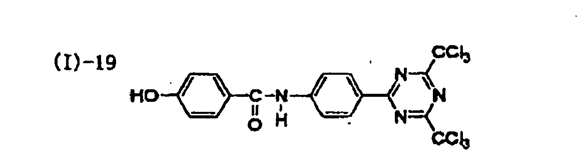

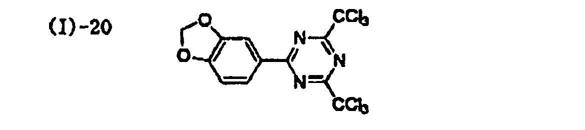

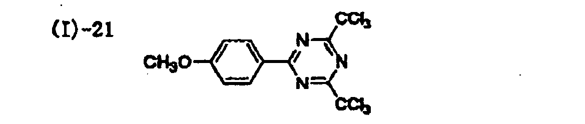

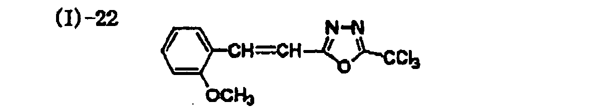

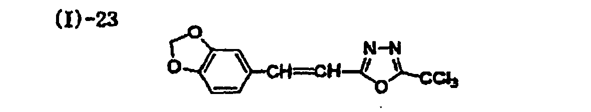

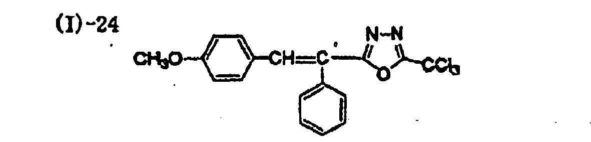

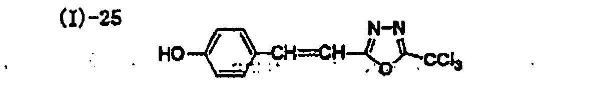

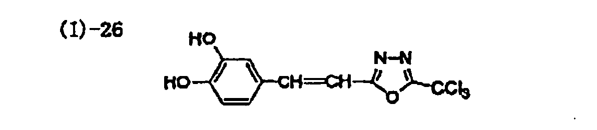

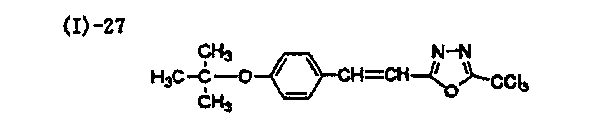

Examples of the carbonyl compound include benzophenone derivatives such as benzophenone, Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1-hydroxycyclohexylphenylketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxantone derivatives such as thioxantone, 2-ethylthioxanthone, 2-isopropylthioxanthone, 2-chlorothioxanthone, 2,4-dimethylthioxanthone, 2,4-diethylthioxanthone and 2,4-diisopropylthioxanthone; benzoic acid ester derivatives such as ethyl p-dimethylaminobenzoate and ethyl p-diethylaminobenzoate.

Examples of the azo-based compound which can be used include azo compounds described in JP-A-8-108621.

Examples of the organic peroxide include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinic peroxide, benzoyl peroxide, 2,4-dichlorobenzoyl peroxide, diisopropylperoxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butylperoxyacetate, tert-butylperoxypivalate, tert-butylperoxyneodecanoate, tert-butylperoxyoctanoate, tert-butylperoxylaurate, tertiary carbonate, 3,3',4,4'-tetra(tert-butyl-peroxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogendiphthalate) and carbonyl di(tert-hexylperoxydihydrogendiphthalate).

Examples of the metallocene compound include various titanocene compounds described in JP-A-59-152396, JP-A-61-151197, JP-A-63-41484, JP-A-2-249, JP-A-2-4705 and JP-A-5-83588, such as dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl and dimethylcyclopentadienyl-Ti-bis-2,3,4,5,6-pentafluorophen-1-yl, and iron-allene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of the organic boron compound include organic borates described in JP-A-62-143044, JP-A-62-150242, JP-A-9-188685, JP-A-9-188686, JP-A-9-188710, JP-A-2000-131837, JP-A-2002-107916, Japanese Patent No. 2764769, JP-A-2002-116539, and Martin Kunz, Rad Tech. '98. Proceeding April 19-22, 1998, Chicago; organic boron sulfonium complexes and organic boron oxosulfonium complexes described in JP-A-6-157623, JP-A-6-175564 and JP-A-6-175561; organic boron iodonium complexes described in JP-A-6-175554 and JP-A-6-175553; organic boron phosphonium complexes described in JP-A-9-188710; and organic boron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin II, 1653-1660 (1979), J.C.S. Perkin II, 156-162 (1979), Journal of Photopolymer Science and Technology, 202-232 (1995), JP-A-2000-66385 and JP-A-2000-80068, Specific examples thereof include the compounds represented by the following structural formulae.

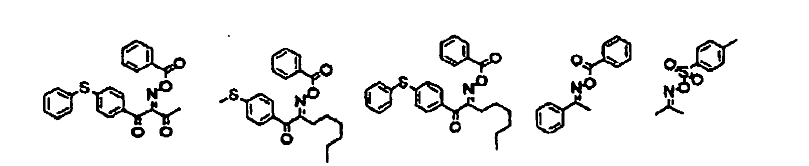

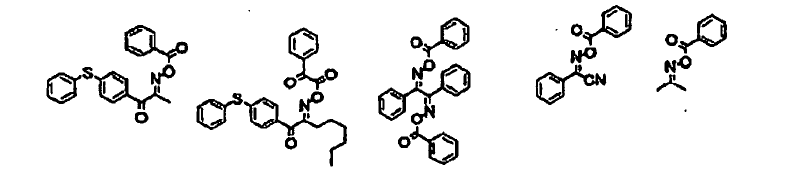

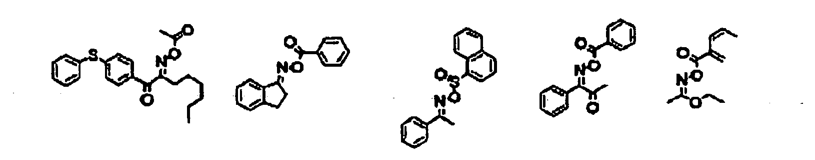

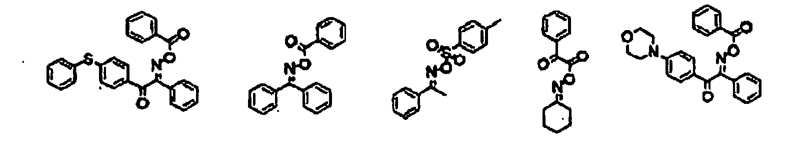

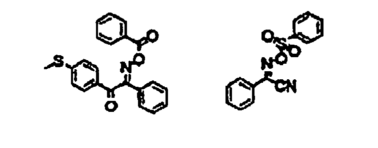

Examples of the onium salt compound include onium salts such as diazonium salts described in S.I. Schlesinger, Photogr. Sci. Eng., 18, 387 (1974) and T.S. Bal et al., Polymer, 21, 423 (1980); ammonium salts described in U.S. Patent 4,069,055 and JP-A-4-365049; phosphonium salts described in U.S. Patents 4,069,055 and 4,069,056; iodonium salts described in European Patent 104,143, U.S. Patents 339,049 and 410,201, JP-A-2-150848 and JP-A-2-296514; sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581; selenonium salts described in J.V. Crivello et al., Macromolecules, 10 (6), 1307 (1977) and J.V. Crivello et al., J. Polymer Sci., Polymer Chem. Ed., 17, 1047 (1979); and arsonium salts described in C. S. Wen et al., Teh. Proc. Conf. Rad. Curing ASIA, p. 478, Tokyo, Oct. (1988).

The onium salt suitably used in the present invention is an onium salt represented by any one of the following formulae (RI-I) to (RI-III):

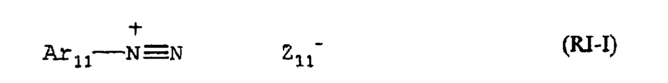

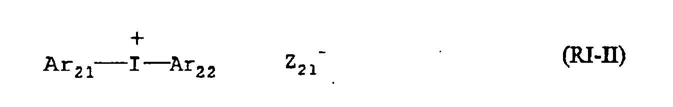

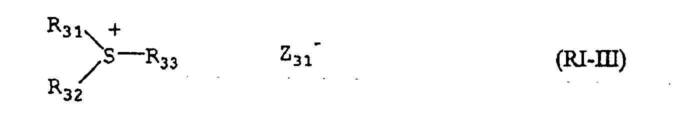

In formula (RI-I), Ar₁₁ represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from I to 12 carbon atoms. Z₁₁ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability are perchlorate ion, hexafluorophosphate ion, tetrafluoroborate ion, sulfonate ion and sulfinate ion.

In formula (RI-II), Ar₂₁ and Ar₂₂ each independently represents an aryl group having 20 or less carbon atoms, which may have from 1 to 6 substituent(s), and preferred examples of the substituent include an alkyl group having from 1 to 12 carbon atoms, an alkenyl group having from 1 to 12 carbon atoms, an alkynyl group having from I to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from I to 12 carbon atoms, and a thioaryl group having from 1 to 12 carbon atoms. Z₂₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Among these, preferred in view of stability and reactivity are perchlorate ion, hexafluorophosphate ion, tetrafluoroborate ion, sulfonate ion, sulfinate ion and carboxylate ion.

In formula (RI-III), R₃₁, R₃₂ and R₃₃ each independently represents an aryl, alkyl, alkenyl or alkynyl group having 20 or less carbon atoms, which may have from 1 to 6 substituent(s), and in view of reactivity and stability, preferably an aryl group. Examples of the substituent include an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxy group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms. Z₃₁⁻ represents a monovalent anion and specific examples thereof include halogen ion, perchlorate ion, hexafluorophosphate ion, tetrafluoroborate ion, sulfonate ion, sulfinate ion, thiosulfonate ion and sulfate ion. Particularly, in view of stability and reactivity, perchlorate ion, hexafluorophosphate ion, tetrafluoroborate ion, sulfonate ion, sulfinate ion and carboxylate ion are preferred, carboxylate ion described in JP-A-2001-343742 is more preferred, and carboxylate ion described in JP-A-2002-148790 is still more preferred.

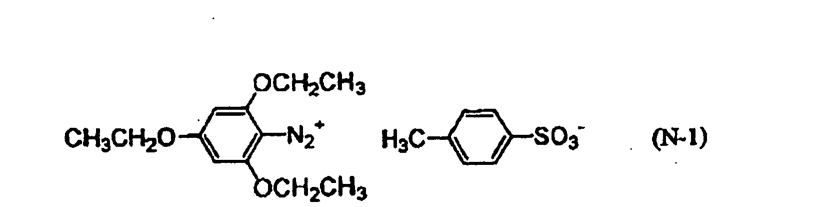

PF₆⁻ (N-2)

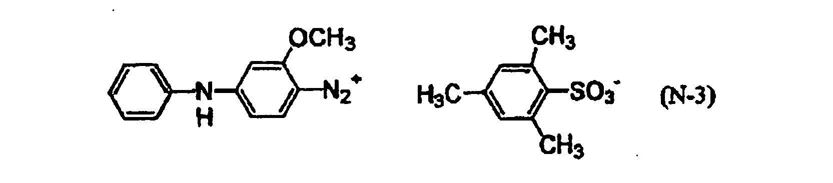

ClO₄⁻ (N-4)

PF₆⁻ (N-5)

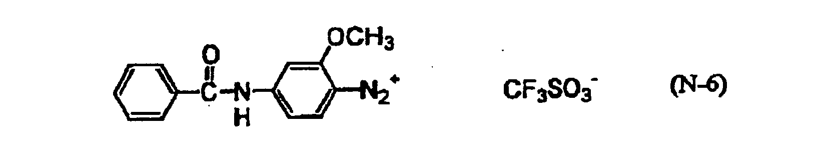

BF₄⁻ (N-7)

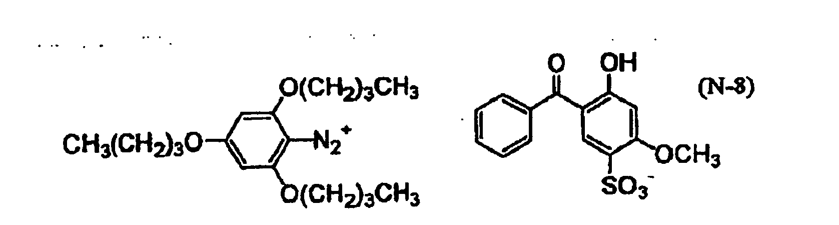

ClO₄⁻ (N-9)

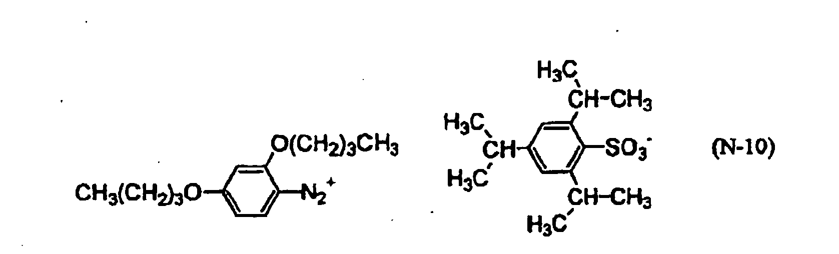

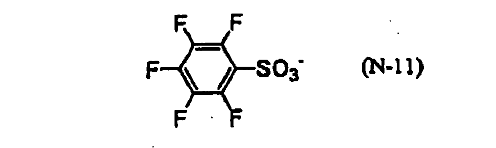

PF₆⁻ (N-12)

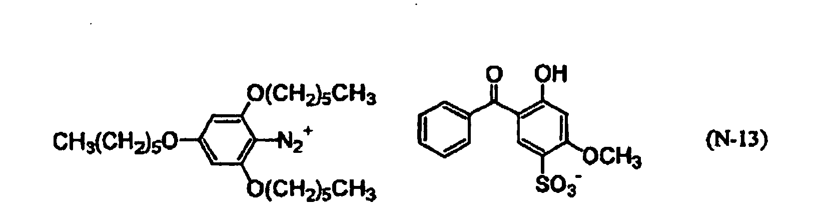

ClO₄⁻ (N-14)

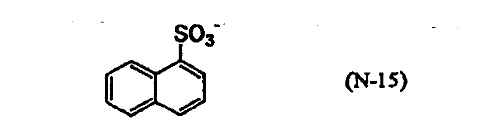

PF₆⁻ (N-16)

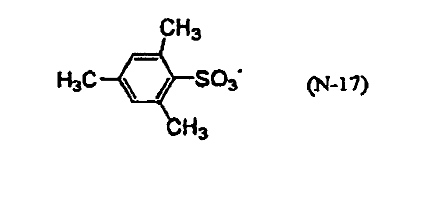

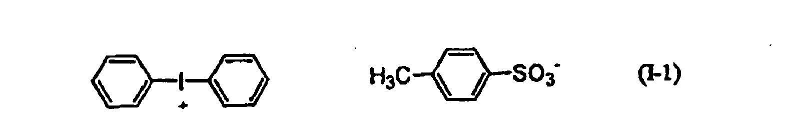

PF₆⁻ (I-2)

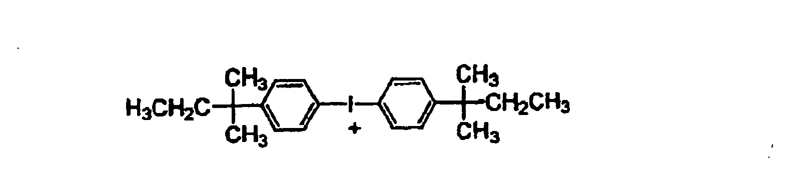

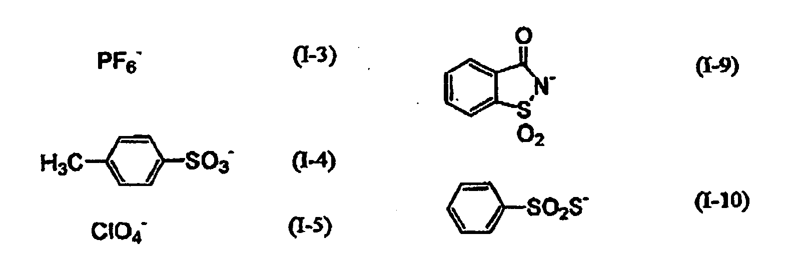

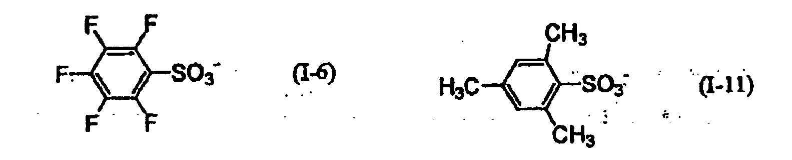

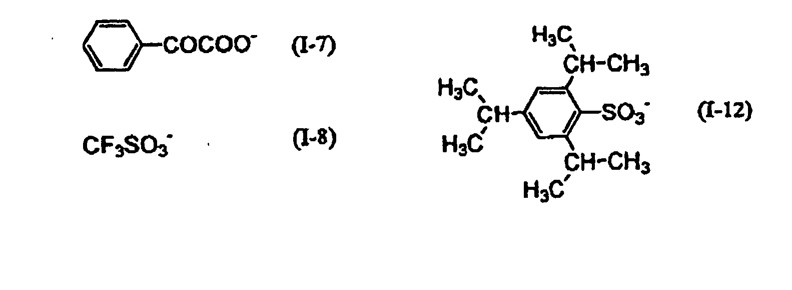

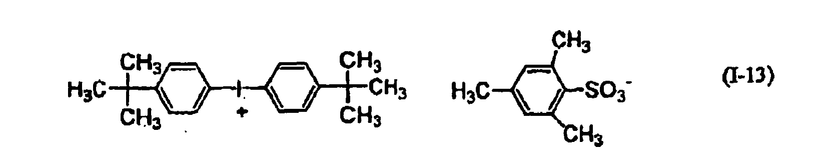

ClO₄⁻ (I-14)

PF₆⁻ (I-15)

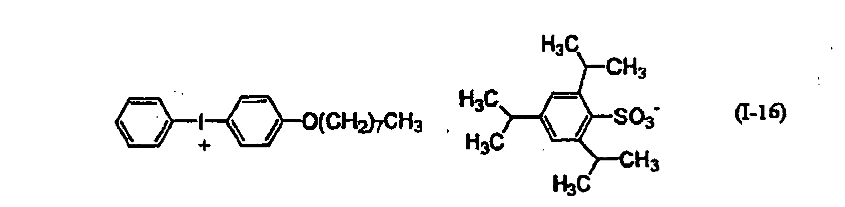

CF₃COO⁻ (I-17)

CF₃SO₃⁻ (I-18)

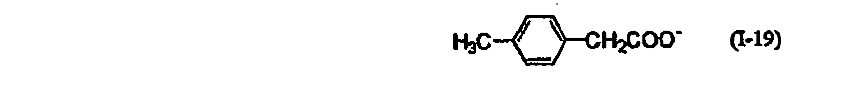

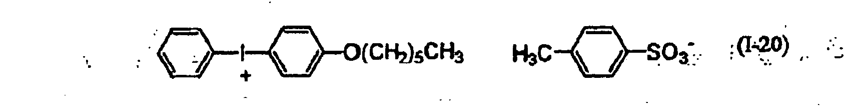

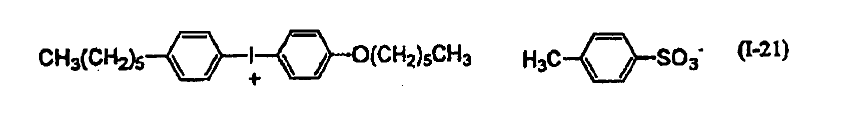

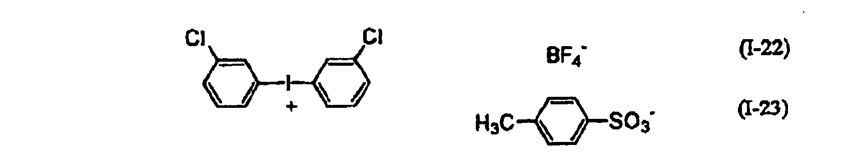

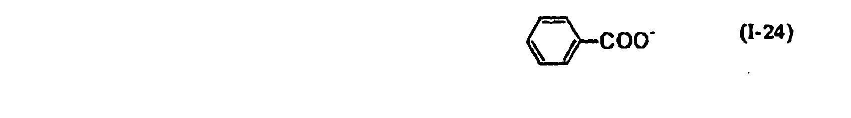

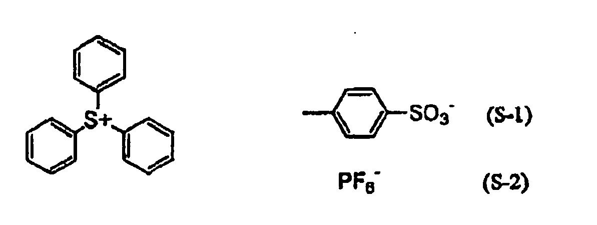

ClO₄⁻ (S-3)

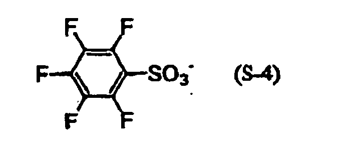

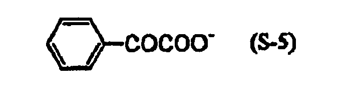

CF₃SO₃⁻ (S-6)

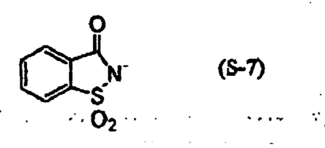

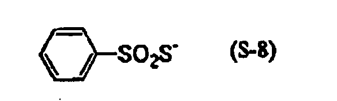

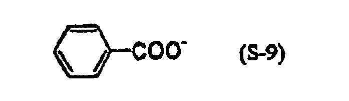

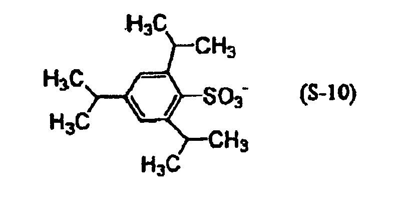

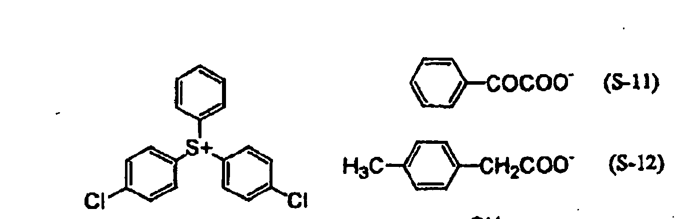

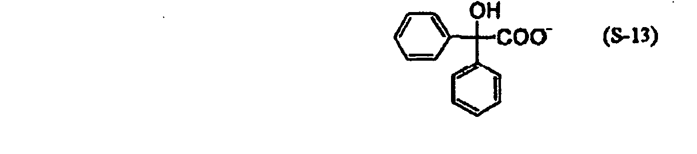

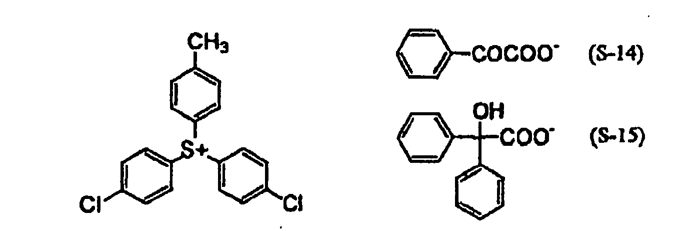

BF₄⁻ (S-16)

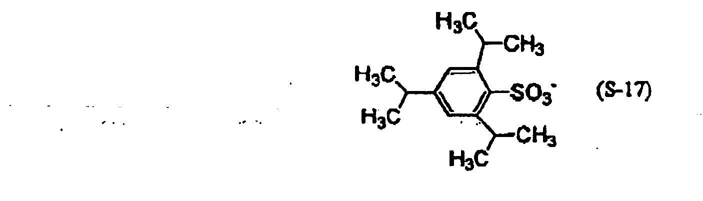

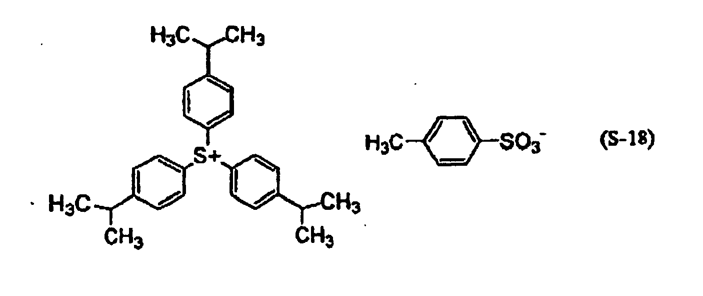

The polymerization initiator is not limited to those described above but particularly, in view of reactivity and stability, triazine-based initiators, organohalogen compounds, oxime ester compounds, diazonium salts, iodonium salts and sulfonium salts are more preferred.

One of these polymerization initiators may be used alone or two or more thereof may be used in combination. The polymerization initiator is added to the same layer as other components. The polymerization initiator can be added at a ratio of preferably from 0.1 to 50 mass%, more preferably from 0.5 to 30 mass%, still more preferably from 0.8 to 20 mass%, based on all solid contents constituting the image recording layer.

### <Polymerizable Compound>

The polymerizable compound which can be used in the present invention is an addition-polymerizable compound having at least one ethylenically unsaturated double bond and is selected from compounds having at least one, preferably two or more, ethylenically unsaturated bond(s). Such compounds are widely known in this industrial field and these known compounds can be used in the present invention without any particular limitation.

These compounds have a chemical mode such as monomer, prepolymer (that is, dimer, trimer or oligomer) or a mixture or copolymer thereof. Examples of the monomer and its copolymer include unsaturated carboxylic acids (e.g., acrylic acid, methacrylic acid, itaconic acid, crotonic acid, isocrotonic acid, maleic acid), and esters and amides thereof. Among these, preferred are esters of an unsaturated carboxylic acid with an aliphatic polyhydric alcohol compound, and amides of an unsaturated carboxylic acid with an aliphatic polyvalent amine compound. Also, addition reaction products of an unsaturated carboxylic acid ester or amide having a nucleophilic substituent such as hydroxyl group, amino group or mercapto group with a monofunctional or polyfunctional isocyanate or epoxy, and dehydrating condensation reaction products with a monofunctional or polyfunctional carboxylic acid may be suitably used. Furthermore, addition reaction products of an unsaturated carboxylic acid ester or amide having an electrophilic substituent such as isocyanate group or epoxy group with a monofunctional or polyfunctional alcohol, amine or thiol, and displacement reaction products of an unsaturated carboxylic acid ester or amide having a disorptive substituent such as halogen group or tosyloxy group with a monofunctional or polyfunctional alcohol, amine or thiol may also be suitably used. Also, compounds where the unsaturated carboxylic acid of the above-described compounds is replaced by an unsaturated phosphonic acid, styrene, vinyl ether or the like, may be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxy-ethyl)isocyanurate, polyester acrylate oligomer and isocyanuric acid EO-modified triacrylate.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane and bis[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate. Examples of the crotonic acid ester include ethylene glycol dicrotonate, tetramethylene glycol dicrotonate, pentaerythritol dicrotonate and sorbitol tetradicrotonate. Examples of the isocrotonic acid ester include ethylene glycol diisocrotonate, pentaerythritol diisocrotonate and sorbitol tetraisocrotonate. Examples of the maleic acid ester include ethylene glycol dimaleate, triethylene glycol dimaleate, pentaerythritol dimaleate and sorbitol tetramaleate.

Examples of other esters include aliphatic alcohol-based esters described in JP-B-51-47334 and JP-A-57-196231, those having an aromatic skeleton described in JP-A-59-5240, JP-A-59-5241 and JP-A-2-226149, and those containing an amino group described in JP-A-1-165613. These ester monomers may also be used as a mixture.

Specific examples of the amide monomer of an aliphatic polyvalent amine compound with an unsaturated carboxylic acid include methylenebisacrylamide, methylene-bismethacrylamide, 1,6-hexamethylenebisacrylamide, 1,6-hexamethylenebismethacrylamide, diethylenetriaminetrisacrylamide, xylylenebisacrylamide and xylylenebismethacrylamide. Other preferred examples of the amide-type monomer include those having a cyclohexylene structure described in JP-B-54-21726.

A urethane-based addition-polymerizable compound produced by using an addition reaction of isocyanate with a hydroxyl group is also preferred and specific examples thereof include vinyl urethane compounds having two or more polymerizable vinyl groups within one molecule described in JP-B-48-41708, which are obtained by adding a vinyl monomer having a hydroxyl group represented by the following formula (A) to a polyisocyanate compound having two or more isocyanate groups within one molecule:

CH₂=C(R₄)COOCH₂CH(R₅)OH (A)

(wherein R₄ and R₅ each represents H or CH₃).

In addition, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used. Furthermore, when addition-polymerizable compounds having an amino or sulfide structure within the molecule described in JP-A-63-277653, JP-A-63-260909 and JP-A-1-105238 are used, a photopolymerizable composition having very excellent photosensitization speed can be obtained.

Other examples include polyfunctional acrylates and methacrylates such as polyester acrylates described in JP-A-48-64183, JP-B-49-43191 and JP-B-52-30490 and epoxy acrylates obtained by reacting an epoxy resin with a (meth)acrylic acid. In addition, specific unsaturated compounds described in JP-B-46-43946, JP-B-1-40337 and JP-B-1-40336, and vinyl phosphonic acid-based compounds described in JP-A-2-25493 may be used.

In some cases, structures containing a perfluoroalkyl group described in JP-A-61-22048 are suitably used. Furthermore, those described as a photocurable monomer or oligomer in Adhesion, Vol. 20, No. 7, pp. 300-308 (1984) may also be used.

Examples of the compound having a vinyl ether group for use in the present invention include compounds described in JP-A-2002-029162. Specific examples thereof include, but are not limited to, tetramethylene glycol divinyl ether, trimethylolpropane trivinyl ether, tetraethylene glycol divinyl ether, pentaerythritol divinyl ether, pentaerythritol trivinyl ether, pentaerythritol tetravinyl ether, 1,4-bis{2-(vinyloxy)ethyloxy}benzene, 1,2-bis{2-(vinyloxy)ethyloxy}benzene, 1,3-bis{2-(vinyloxy)ethyloxy}benzene, 1,3,5-tris{2-(vinyloxy)ethyloxy}benzene, 4,4'-bis{2-(vinyloxy)ethyloxy}biphenyl, 4,4'-bis{2-(vinyloxy)ethyloxy}diphenylether, 4,4'-bis{2-(vinyloxy)ethyloxy}diphenylmethane, 1,4-bis{2-(vinyloxy)ethyloxy}naphthalene, 2,5-bis{2-(vinyloxy)ethyloxy}furan, 2,5-bis{2-(vinyloxy)ethyloxy}thiophene, 2,5-bis{2-(vinyloxy)ethyloxy}imidazole, 2,2-bis[4-{2-(vinyloxy)ethyloxy}phenyl]propane {bis(vinyloxyethyl)ether of bisphenol A), 2,2-bis{4-(vinyloxymethyloxy)phenyl}propane and 2,2-bis{4-(vinyloxy)phenyl}propane.

Details of the usage of these addition-polymerizable compounds, such as structure, sole or combination use and amount added, can be freely selected in accordance with the performance design of final lithographic printing plate precursor and, for example, may be selected from the following standpoints.

In view of sensitivity, a structure having a large unsaturated group content per one molecule is preferred and in many cases, a bifunctional or greater functional compound is preferred. For increasing the strength of image area, namely, cured film, a trifunctional or greater functional compound is preferred. Also, a method of controlling both sensitivity and strength by using a combination of compounds differing in the functional number and in the polymerizable group (for example, an acrylic acid ester, a methacrylic acid ester, a styrene-based compound or a vinyl ether-based compound) is effective.

The selection and usage of the addition-polymerizable compound are important factors also for the compatibility and dispersibility with other components (e.g., water-insoluble polymer, initiator, colorant) in the image recording layer. For example, the compatibility may be improved in some cases by using a low purity compound or using two or more compounds in combination. Also, a specific structure may be selected for the purpose of enhancing the adhesion to the substrate, protective layer which is described later, or the like.

The polymerizable compound is preferably used in an amount of 5 to 80 mass%, more preferably from 25 to 75 mass%, based on all solid contents constituting the image recording layer. Also, these polymerizable compounds may be used individually or in combination of two or more thereof.

### <Hydrophobic Binder Polymer>

The hydrophobic binder polymer for use in the image recording layer of the present invention is preferably a water-insoluble polymer. The hydrophobic binder polymer usable in the present invention preferably contains substantially no acid group such as carboxyl group, sulfone group and phosphoric acid group. The acid value (acid content per g of polymer, expressed by the chemical equivalent number) of the binder polymer is preferably 0.3 meq/g or less, more preferably 0.1 meq/g or less. That is, the hydrophobic binder polymer usable in the present invention is preferably insoluble in water or an aqueous solution at a pH of 10 or more, and the solubility of the hydrophobic binder polymer in water or an aqueous solution at a pH of 10 or more is preferably 0.5 mass% or less, more preferably 0.1 mass% or less. By using such a hydrophobic binder polymer, the film strength, water resistance and inking property of the image recording layer are elevated and an enhanced press life can be obtained.

As for the hydrophobic binder polymer, conventionally known hydrophobic binder polymers preferably having a solubility in the above-described range can be used without limitation as long as the performance of the lithographic printing plate of the present invention is not impaired, but a linear organic polymer having film property is preferred.

Preferred examples of such a hydrophobic binder polymer include a polymer selected from acrylic resin, polyvinyl acetal resin, polyurethane resin, polyamide resin, epoxy resin, methacrylic resin, styrene-based resin and polyester resin. Among these, acrylic resin is preferred, and a (meth)acrylic acid ester copolymer is more preferred. More specifically, a copolymer of a (meth)acrylic acid alkyl or aralkyl ester with a (meth)acrylic acid ester containing a -CH₂CH₂O- or -CH₂CH₂NH- unit in R of the ester residue (-COOR) of the (meth)acrylic acid ester is particularly preferred. The alkyl group in the (meth)acrylic acid alkyl ester is preferably an alkyl group having from 1 to 5 carbon atoms, more preferably a methyl group. Preferred examples of the (meth)acrylic acid aralkyl ester include benzyl (meth)acrylate.

The hydrophobic binder polymer may be imparted with a crosslinking property so as to enhance the film strength in the image area. The crosslinking property may be imparted to the hydrophobic binder polymer by introducing a crosslinking functional group such as ethylenically unsaturated bond into the polymer. The crosslinking functional group may be introduced by copolymerization. Examples of the hydrophobic binder polymer having an ethylenically unsaturated bond within the molecule include polymers which are a polymer of acrylic or methacrylic acid ester or amide and in which the ester or amide residue (R' in - COOR' or -CONHR') has an ethylenically unsaturated bond.

Examples of the residue (R' above) having an ethylenically unsaturated bond include -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X (wherein R¹ to R³ each represents a hydrogen atom, a halogen atom or an alkyl, aryl, alkoxy or aryloxy group having from 1 to 20 carbon atoms, R¹ and R² or R³ may combine with each other to form a ring, n represents an integer of 1 to 10, and X represents a dicyclopentadienyl residue).

Specific examples of the ester residue include -CH₂CH=CH₂ (described in JP-B-7-21633), -CH₂CH₂O-CH₂CH=CH₂, -CH₂C(CH₃)=CH₂, -CH₂CH=CH-C₆H₅, - CH₂CH₂OCOCH=CH-C₆H₅, -CH₂CH₂-NHCOO-CH₂CH=CH₂ and -CH₂CH₂O-X (wherein X represents a dicyclopentadienyl residue).

Specific examples of the amide residue include -CH₂CH=CH₂, -CH₂CH₂-Y (wherein Y represents a cyclohexene residue) and -CH₂CH₂-OCO-CH=CH₂.

In the hydrophobic binder polymer having a crosslinking property, for example, a free radical (a polymerization initiating radical or a radical grown in the process of polymerization of a polymerizable compound) is added to the crosslinking functional group to cause an addition-polymerization between polymers directly or through a polymerization chain of the polymerizable compound, as a result, crosslinking is formed between polymer molecules and thereby curing is effected. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between polymer molecules, thereby effecting curing.

The content of the crosslinking group (content of radical-polymerizable unsaturated double bond determined by iodine titration) in the binder polymer is preferably from 0.1 to 10.0 mmol, more preferably from 1.0 to 7.0 mmol, and most preferably from 2.0 to 5.5 mmol, per g of the hydrophobic binder polymer.

From the standpoint of enhancing the developability with an aqueous solution, the binder polymer is preferably hydrophilic. Also, from the standpoint of enhancing the press life, it is important that the binder polymer has good compatibility with the polymerizable compound contained in the image recording layer, that is, the binder polymer is preferably lipophilic. In this light, it is also effective in the present invention to copolymerize a hydrophilic group and a lipophilic group in the hydrophobic binder polymer and thereby enhance the developability and the press life. Examples of the hydrophilic group which can be suitably used include those having a hydrophilic group such as hydroxy group, carboxylate group, hydroxyethyl group, ethyleneoxy group, hydroxypropyl group, polyoxyethyl group, polyoxypropyl group, amino group, aminoethyl group, aminopropyl group, ammonium group, amide group and carboxymethyl group.

The hydrophobic binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The hydrophobic binder polymer may be a random polymer, a block polymer, a graft polymer or the like but is preferably a random polymer.

The hydrophobic binder polymers may be used individually or in combination of two or more thereof.

The content of the hydrophobic binder polymer is from 5 to 90 mass%, preferably from 10 to 70 mass%, more preferably from 10 to 60 mass%, based on the entire solid content of the image recording layer. Within this range, good strength of image area and good image-forming property can be obtained.

### <Infrared Absorbent>

In the image recording layer of the lithographic printing plate precursor which is imagewise exposed by using a light source of emitting infrared ray, an infrared absorbent can be used in combination with the above-described polymerization initiator. The infrared absorbent has a function of converting the absorbed infrared ray into heat. By the effect of heat generated here, the polymerization initiator is thermally decomposed and generates a radical. The infrared absorbent for use in the present invention is a dye or pigment having an absorption maximum at a wavelength of 760 to 1,200 nm.

As for the dye, commercially available dyes and known dyes described in publications, for example, Senryo Binran (Handbook of Dyes), compiled by Yuki Gosei Kagaku Kyokai (1970), may be used. Specific examples thereof include dyes such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiapyrylium salts described in U.S. Patent 4,283,475, and pyrylium compounds described in JP-B-5-13514 and JP-B-5-19702 may also be preferably used. Other preferred examples of the dye include near infrared absorbing dyes represented by formulae (I) and (II) of U.S. Patent 4,756,993.

Among these dyes, particularly preferred are cyanine dye, squarylium dye, pyrylium salt, nickel thiolate complex and indolenine cyanine dye, more preferred are cyanine dye and indolenine cyanine dye, still more preferred is a cyanine dye represented by the following formula (II):

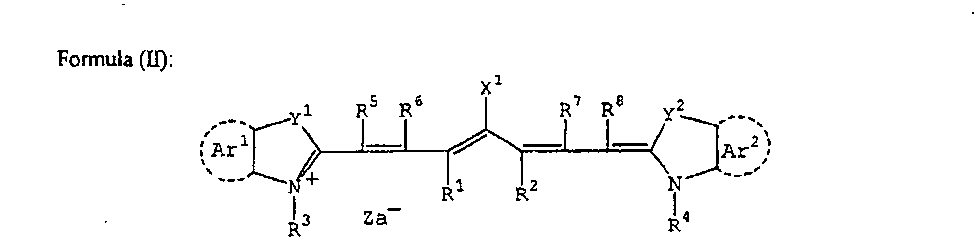

In formula (II), X¹ represents a hydrogen atom, a halogen atom, -NPh₂, X²-L¹ or a group shown below: 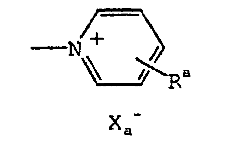 wherein X² represents an oxygen atom, a nitrogen atom or a sulfur atom, L¹ represents a hydrocarbon group having from 1 to 12 carbon atoms, an aromatic ring having a heteroatom, or a hydrocarbon group having from 1 to 12 carbon atoms and containing a heteroatom (the heteroatom as used herein indicates N, S, O, a halogen atom or Se), Xₐ⁻ has the same definition as Za⁻ described later, and R^{a} represents a substituent selected from a hydrogen atom, an alkyl group, an aryl group, a substituted or unsubstituted amino group and a halogen atom.

R¹ and R² each independently represents a hydrocarbon group having from 1 to 12 carbon atoms. In view of storage stability of the coating solution for the recording layer, R¹ and R² each is preferably a hydrocarbon group having 2 to more carbon atoms, and R¹ and R² are more preferably combined with each other to form a 5- or 6-membered ring.

Ar¹ and Ar² may be the same or different and each represents an aromatic hydrocarbon group which may have a substituent. Preferred examples of the aromatic hydrocarbon group include a benzene ring and a naphthalene ring, and preferred examples of the substituent include a hydrocarbon group having 12 or less carbon atoms, a halogen atom and an alkoxy group having 12 or less carbon atoms. Y¹ and Y² may be the same or different and each represents a sulfur atom or a dialkylmethylene group having 12 or less carbon atoms. R³ and R⁴ may be the same or different and each represents a hydrocarbon group having 20 or less carbon atoms, which may have a substituent. Preferred examples of the substituent include an alkoxy group having 12 or less carbon atoms, a carboxyl group and a sulfo group. R⁵, R⁶, R⁷ and R⁸ may be the same or different and each represents a hydrogen atom or a hydrocarbon group having 12 or less carbon atoms, and in view of availability of the raw material, preferably a hydrogen atom. Za⁻ represents a counter anion, but when the cyanine dye represented by formula (II) has an anionic substituent in its structure and neutralization of electric charge is not necessary, Za⁻ is not present. In view of storage stability of the coating solution for the recording layer, Za⁻ is preferably halogen ion, perchlorate ion, tetrafluoroborate ion, hexafluorophosphate ion or sulfonate ion, more preferably perchlorate ion, hexafluorophosphate ion or arylsulfonate ion.

Specific examples of the cyanine dye represented by formula (II), which can be suitably used in the present invention, include those described in paragraphs [0017] to [0019] of JP-A-2001-133969.

Other preferred examples include specific indolenine cyanine dyes described in JP-A-2002-278057.

As for the pigment used as the infrared absorbent in the present invention, commercially available pigments and pigments described in Color Index (C.I.) Binran (C.I. Handbook), Saishin Ganryo Binran (Handbook of Newest Pigments), compiled by Nippon Ganryo Gijutsu Kyokai (1977), Saishin Ganryo Oyo Gijutsu (Newest Pigment Application Technology), CMC Shuppan (1986), and Insatsu Ink Gijutsu (Printing Ink Technology), CMC Shuppan (1984) can be used.

The kind of pigment includes black pigment, yellow pigment, orange pigment, brown pigment, red pigment, violet pigment, blue pigment, green pigment, fluorescent pigment, metal powder pigment and polymer bond pigment. Specific examples of the pigment which can be used include insoluble azo pigments, azo lake pigments, condensed azo pigments, chelate azo pigments, phthalocyanine-based pigments, anthraquinone-based pigments, perylene- and perynone-based pigments, thioindigo-based pigments, quinacridone-based pigments, dioxazine-based pigments, isoindolinone-based pigments, quinophthalone-based pigments, dyed lake pigments, azine pigments, nitroso pigments, nitro pigments, natural pigments, fluorescent pigments, inorganic pigments and carbon black. Among these pigments, carbon black is preferred.

These pigments may or may not be surface-treated before use. Examples of the method for surface treatment include a method of coating the surface with resin or wax, a method of attaching a surfactant, and a method of bonding a reactive substance (for example, silane coupling agent, epoxy compound or isocyanate) to the pigment surface. These surface-treating methods are described in Kinzoku Sekken no Seishitsu to Oyo (Properties and Application of Metal Soap), Saiwai S hobo, Insatsu Ink Gijutsu (Printing Ink Technology), CMC Shuppan (1984), and Saishin Ganryo Oyo Gijutsu (Newest Pigment Application Technology), CMC Shuppan (1986).

The particle diameter of the pigment is preferably from 0.01 to 10 µm, more preferably from 0.05 to 1 µm, still more preferably from 0.1 to 1 µm. Within this range, good stability of the pigment dispersion in the coating solution for the image recording layer and good uniformity of the image recording layer can be obtained.

For dispersing the pigment, a known dispersion technique used in the production of ink or toner may be used. Examples of the dispersing machine include ultrasonic disperser, sand mill, attritor, pearl mill, super-mill, ball mill, impeller, disperser, KD mill, colloid mill, dynatron, three-roll mill and pressure kneader. These are described in detail in Saishin Ganryo Oyo Gijutsu (Newest Pigment Application Technology), CMC Shuppan (1986).

The infrared absorbent has a side effect of inhibiting the polymerization reaction and in order to suppress this side effect, the amount of the infrared absorbent added to the image recording layer is preferably a necessary minimum amount.

The infrared absorbent can be added at a ratio of preferably from 0.001 to 50 mass%, more preferably from 0.005 to 30 mass%, still more preferably from 0.01 to 10 mass%, based on the entire solid content of the image recording layer. Within this range, high sensitivity can be obtained without adversely affecting the uniformity or film strength of the image recording layer.

### <Sensitizer>

In the image recording layer of the lithographic printing plate precursor which is imagewise exposed by using a light source of emitting light at 250 to 420 nm, a sensitizer may also be used in combination with the above-described polymerization initiator so as to elevate the radical generation efficiency.

Specific examples of the sensitizer include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-tert-butyl-9,10-anthraquinone, 2,6-dichloro-9,10-anthraquinone, xanthone, 2-methylxanthone, 2-methoxyxanthone, thioxanthone, benzyl, dibenzylacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone.

Furthermore, preferred examples of the sensitizer for use in the present invention include compounds represented by formula (III) described in JP-B-51-48516: 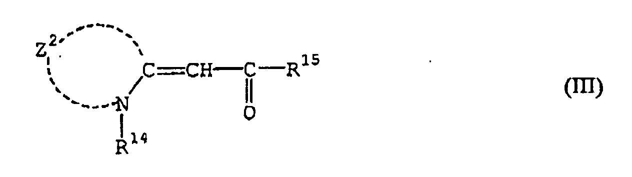 wherein R¹⁴ represents an alkyl group (e.g., methyl, ethyl, propyl) or a substituted alkyl group (e.g., 2-hydroxyethyl, 2-methoxyethyl, carboxymethyl, 2-carboxyethyl); R¹⁵ represents an alkyl group (e.g., methyl, ethyl) or an aryl group (e.g., phenyl, p-hydroxyphenyl, naphthyl, thienyl); and

Z² represents a nonmctallic atom group necessary for forming a nitrogen-containing heterocyclic nucleus usually used in cyanine dyes, for example, benzothiazoles (e.g., benzothiazole, 5-chlorobenzothiazole, 6-chlorobenzothiazole), naphthothiazoles (e.g., α-naphthothiazole, β-naphthothiazole), benzoselenazoles (e.g., benzoselenazole, 5-chlorobenzoselenazole, 6-methoxybenzoselenazole), naphthoselenazoles (e.g., α-naphthoselenazole, β-naphthoselenazole), benzoxazoles (e.g., benzoxazole, 5-methylbenzoxazole, 5-phenylbenzoxazole), naphthoxazoles (e.g., α-naphthoxazole, β-naphthoxazole).

Specific examples of the compound represented by formula (III) include those having a chemical structure constituted by combining these Z², R¹⁴ and R¹⁵. Many of such compounds are present as a known substance and therefore, the compound may be appropriately selected and used from those known substances. Other preferred examples of the sensitizer for use in the present invention include merocyanine dyes described in JP-B-5-47095 and ketocoumarin-based compounds represented by the following formula (IV): 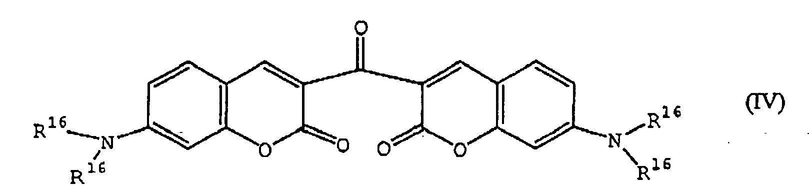 wherein R¹⁶ represents an alkyl group such as methyl group and ethyl group.

The sensitizer can be added at a ratio of preferably from 0.1 to 50 mass%, more preferably from 0.5 to 30 mass%, still more preferably from 0.8 to 20 mass%, based on all solid contents constituting the image recording layer.

### <Microcapsule>

In the present invention, the above-described components constituting the image recording layer and other constituent components described later may be incorporated into the image recording layer by a method of partially enclosing the constituent components in a microcapsule and adding the microcapsule to the image recording layer described, for example, in JP-A-2001-277740 and JP-A-2001-277742. In this case, the constituent components may be incorporated inside and outside the microcapsule at an arbitrary ratio.

For microencapsulating the constituent components of the image recording layer, conventionally known methods can be used. Examples of the method for producing a microcapsule include, but are not limited to, a method utilizing coacervation described in U.S. Patents 2,800,457 and 2,800,458, a method utilizing interfacial polymerization described in U.S. Patent 3,287,154, JP-B-38-19574 and JP-B-42-446, a method utilizing precipitation of polymer described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method utilizing monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,074.

The microcapsule wall for use in the present invention preferably has a three-dimensionally crosslinked structure and has a property of swelling with a solvent. From this standpoint, the wall material of microcapsule is preferably polyurea, polyurethane, polyester, polycarbonate, polyamide or a mixture thereof, more preferably polyurea or polyurethane. Also, a compound having a crosslinking functional group such as ethylenically unsaturated bond which can be introduced into the above-described water-insoluble polymer may be introduced into the microcapsule wall.

The average particle size of the microcapsule is preferably from 0.01 to 3.0 µm, more preferably from 0.05 to 2.0 µm, still more preferably from 0.10 to 1.0 µm, Within this range, good resolution and good aging stability can be obtained.

### <Other Components of Image Recording Layer>

The image recording layer of the present invention may further contain various additives, if desired. These are described below.

### <Hydrophilic Polymer>

The image recording layer in the lithographic printing plate precursor of the present invention may contain a hydrophilic polymer so as to enhance the developability and elevate the dispersion stability of microcapsules.

Suitable examples of the hydrophilic polymer include those having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, starch derivatives, carboxymethyl cellulose and sodium salt thereof, cellulose acetate, sodium alginate, vinyl acetate-maleic acid copolymers, styrene-maleic acid copolymers, polyacrylic acids and salts thereof, polymethacrylic acids and salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetates having a hydrolysis degree of 60 mol% or more, preferably 80 mol% or more, polyvinyl formal, polyvinyl butyral, polyvinylpyrrolidone, homopolymers and polymers of acrylamide, homopolymers and copolymers of methacrylamide, homopolymers and copolymers of N-methylolacrylamide, polyvinylpyrrolidone, alcohol-soluble nylons, and polyethers of 2,2-bis-(4-hydroxyphenyl)-propane with epichlorohydrin.

The hydrophilic polymer preferably has a weight average molecular weight of 5,000 or more, more preferably from 10,000 to 300,000. The hydrophilic polymer may be a random polymer, a block polymer, a graft polymer or the like.

The content of the hydrophilic polymer in the image recording layer is preferably 20 mass% or less, more preferably 10 mass% or less, based on the entire solid content of the image recording layer.

### <Surfactant>

In the present invention, a surfactant is preferably used in the image recording layer so as to accelerate the development and enhance the coated surface state. The surfactant includes a nonionic surfactant, an anionic surfactant, a cationic surfactant, an amphoteric surfactant, a fluorine-containing surfactant and the like.

The surfactants may be used individually or in combination of two or more thereof.

The nonionic surfactant for use in the present invention is not particularly limited and a conventionally known nonionic surfactant can be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamines, triethanolamine fatty acid esters, trialkylamine oxides, polyethylene glycol, and copolymers of polyethylene glycol and polypropylene glycol.

The anionic surfactant for use in the present invention is not particularly limited and a conventionally known anionic surfactant can be used. Examples thereof include fatty acid salts, abietates, hydroxyalkanesulfonates, alkanesulfonates, dialkylsulfosuccinic ester salts, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated beef tallow oils, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified products of styrene/maleic anhydride copolymer, partially saponified products of olefin/maleic anhydride copolymer, and naphthalenesulfonate formalin condensates.

The cationic surfactant for use in the present invention is not particularly limited and a conventionally known cationic surfactant can be used. Examples thereof include alkylamine salts, quaternary ammonium salts, polyoxyethylene alkylamine salts and polyethylene polyamine derivatives.

The amphoteric surfactant for use in the present invention is not particularly limited and a conventionally known amphoteric surfactant can be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene and polyoxybutylene, and these surfactants can also be used in the present invention.

The surfactant is more preferably a fluorine-containing surfactant containing a perfluoroalkyl group within the molecule. This fluorine-containing surfactant includes an anionic type such as perfluoroalkylcarboxylate, perfluoroalkylsulfonate and perfluoroalkylphosphoric ester; an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

The surfactants can be used individually or in combination of two or more thereof.

The surfactant content is preferably from 0.001 to 10 mass%, more preferably from 0.01 to 7 mass%, based on the entire solid content of the image recording layer.

### <Colorant>

In the present invention, a dye having large absorption in the visible light region can be used as a colorant of the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industry Co., Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes described in JP-A-62-293247. Also, pigments such as phthalocyanine-based pigment, azo-based pigment, carbon black and titanium oxide may be suitably used.

The colorant is preferably added, because the image area and the non-image area after image formation can be clearly distinguished. The amount of the colorant added is preferably from 0.01 to 10 mass% based on the entire solid content of the image recording material.

### <Printing-Out Agent>

In the image recording layer of the present invention, a compound of undergoing discoloration by the effect of an acid or a radical can be added so as to produce a print-out image. Various dyes such as diphenylmethane-based, triphenylmethane-based, thiazine-based, oxazine-based, xanthene-based, anthraquinone-based, iminoquinone-based and azomethine-based dyes are effective as such a compound.

Specific examples thereof include dyes such as Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH [produced by Hodogaya Chemical Co., Ltd.], Oil Blue #603 [produced by Orient Chemical Industry Co., Ltd.], Oil Pink #312 [produced by Orient Chemical Industry Co., Ltd.], Oil Red 5B [produced by Orient Chemical Industry Co., Ltd.], Oil Scarlet #308 [produced by Orient Chemical Industry Co., Ltd.], Oil Red OG [produced by Orient Chemical Industry Co., Ltd.], Oil Red RR [produced by Orient Chemical Industry Co., Ltd.], Oil Green #502 [produced by Orient Chemical Industry Co., Ltd.], Spiron Red BEH Special [produced by Hodogaya Chemical Co., Ltd.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carbostearylamino-4-p-N,N-bis(hydroxyethyl)aminophenyliminonaphthoquinone, 1-phenyl-3-methyl-4-p-diethylaminophenylimino-5-pyrazolone and 1-β-naphthyl-4-p-diethylaminophenylimino-5-pyrazolone, and leuco dyes such as p,p',p"-hexamethyltriaminotriphenyl methane (Leuco Crystal Violet) and Pergascript Blue SRB (produced by Ciba Geigy).

Other suitable examples include leuco dyes known as a material for heat-sensitive or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(NN-diethylamino)-5-methyl-7-(N,N-dibenzylamino)-fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilino-fluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-phthalide and 3-(4-diethylaminophenyl)-3-(1-ethyl-2-methylindol-3-yl)phthalide.

The dye of undergoing discoloration by the effect of an acid or a radical is preferably added in an amount of 0.01 to 15 mass% based on the solid content of the image recording layer.

### <Polymerization Inhibitor>

In the image recording layer of the present invention, a small amount of a thermopolymerization inhibitor is preferably added so as to prevent the polymerizable compound from undergoing unnecessary thermopolymerization during the preparation or storage of the image recording layer.

Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The thermopolymerization inhibitor is preferably added in an amount of about 0.01 to about 5 mass% based on the entire solid content of the image recording layer.

### <Higher Fatty Acid Derivative, etc.>

In the image recording layer of the present invention, for example, a higher fatty acid derivative such as behenic acid or behenic acid amide may be added and localized on the surface of the image recording layer during drying after coating so as to prevent polymerization inhibition by oxygen. The amount of the higher fatty acid derivative added is preferably from about 0.1 to about 10 mass% based on the entire solid content of the image recording layer.

### <Plasticizer>

The image recording layer of the present invention may contain a plasticizer. Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate; glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate. The plasticizer content is preferably about 30 mass% or less based on the entire solid content of the image recording layer.

### <Inorganic Fine Particle>

The image recording layer of the present invention may contain an inorganic fine particle so as to elevate the cured film strength in the image area. Suitable examples of the inorganic fine particle include silica, alumina, magnesium oxide, titanium oxide, magnesium carbonate, calcium alginate and a mixture thereof. Even if such an inorganic fine particle has no light-to-heat converting property, the inorganic fine particle can be used, for example, for strengthening the film or roughening the surface to enhance the interfacial adhesion. The average particle diameter of the inorganic fine particle is preferably from 5 nm to 10 µm, more preferably from 0.5 to 3 µm. Within this range, the inorganic particles are stably dispersed in the image recording layer, so that the image recording layer can maintain sufficiently high film strength and the non-image area formed can ensure excellent hydrophilicity and less staining at printing.

Such an inorganic fine particle is easily available on the market as a colloidal silica dispersion or the like.

The inorganic fine particle content is preferably 20 mass% or less, more preferably 10 mass% or less, based on the entire solid content of the image recording layer.

### <Low-Molecular Hydrophilic Compound>

The image recording layer of the present invention may contain a hydrophilic low-molecular compound so as to enhance the developability. Examples of the hydrophilic low-molecular compound include, as the water-soluble organic compound, glycols and ether or ester derivatives thereof, such as ethylene glycol, diethylene glycol, triethylene glycol, propylene glycol, dipropylene glycol and tripropylene glycol; polyhydroxys such as glycerin and pentaerythritol; organic amines and salts thereof, such as triethanolamine, diethanolamine and monoethanolamine; organic sulfonic acids and salts thereof, such as toluenesulfonic acid and benzenesulfonic acid; organic phosphonic acids and salts thereof, such as phenylphosphonic acid; and organic carboxylic acids and salts thereof, such as tartaric acid, oxalic acid, citric acid, malic acid, lactic acid, gluconic acid and amino acids.

### <Formation of Image Recording Layer>

The image recording layer of the present invention is formed by dispersing or dissolving the above-described necessary components in a solvent to prepare a coating solution and coating the obtained coating solution. Examples of the solvent used here include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyl lactone, toluene and water. These solvents are used individually or in combination. The concentration of solid content in the coating solution is preferably from 1 to 50 mass%.

The image recording layer of the present invention may also be formed by dispersing or dissolving the same or different components described above in the same or different solvents to prepare a plurality of coating solutions and repeating the coating and drying multiple times.

The coated amount (solid content) of the image recording layer obtained on the support after coating and drying varies depending on the use but, in general, is preferably from 0.3 to 3.0 g/m². Within this range, good sensitivity and good film properties of the image recording layer can be obtained.

For the coating, various methods may be used and examples thereof include bar coater coating, rotary coating, spray coating, curtain coating, dip coating, air knife coating, blade coating and roll coating.

### (Support)

The support for use in the lithographic printing plate precursor of the present invention is not particularly limited and may be sufficient if it is a dimensionally stable platelike hydrophilic support. Examples thereof include paper, paper laminated with plastic (e.g., polyethylene, polypropylene, polystyrene), metal plate (e.g., aluminum, zinc, copper), plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or plastic film laminated or vapor-deposited with the above-described metal. Among these supports, polyester film and aluminum plate are preferred, and aluminum plate is more preferred because this is dimensionally stable and relatively inexpensive.

The aluminum plate is a pure aluminum plate, an alloy plate mainly comprising aluminum and containing trace heteroelements, or an aluminum or aluminum alloy thin film laminated with a plastic. Examples of the heteroelement contained in the aluminum alloy include silicon, iron, manganese, copper, magnesium, chromium, zinc, bismuth, nickel and titanium. The heteroelement content in the alloy is preferably 10 mass% or less. In the present invention, a pure aluminum plate is preferred, but perfectly pure aluminum is difficult to produce in view of refining technique and therefore, an aluminum plate containing trace heteroelements may be used. The aluminum plate is not particularly limited in its composition, and a conventionally known and commonly employed material can be appropriately used.

The thickness of the support is preferably from 0.1 to 0.6 mm, more preferably from 0.15 to 0.4 mm, still more preferably from 0.2 to 0.3 mm.

In advance of using the aluminum plate, the aluminum plate is preferably subjected to a surface treatment such as surface roughening and anodization. This surface treatment facilitates enhancing hydrophilicity and ensuring adhesion between the image recording layer and the support. Prior to the surface-roughening of aluminum plate, a degreasing treatment for removing the rolling oil on the surface is performed, if desired, by using a surfactant, an organic solvent, an alkaline aqueous solution or the like.

The surface-roughening treatment of the aluminum plate surface is performed by various methods and examples thereof include a mechanical surface-roughening treatment, an electrochemical surface-roughening treatment (a surface-roughening treatment of electrochemically dissolving the surface) and a chemical surface-roughening treatment (a surface-roughening treatment of chemically and selectively dissolving the surface).

The mechanical surface-roughening treatment may be performed by using a known method such as ball polishing, brush polishing, blast polishing and buff polishing.

The method for the electrochemical surface-roughening treatment includes, for example, a method of passing an alternating or direct current in an electrolytic solution containing an acid such as hydrochloric acid or nitric acid. Also, a method using a mixed acid described in JP-A-54-63902 may be used.

The surface-roughened aluminum plate is, if desired, subjected to an alkali etching treatment using an aqueous solution of potassium hydroxide, sodium hydroxide or the like and after a neutralization treatment, further subjected to an anodization treatment, if desired, so as to enhance the abrasion resistance.

As for the electrolyte for use in the anodization treatment of the aluminum plate, various electrolytes of forming a porous oxide film may be used. In general, a sulfuric acid, a hydrochloric acid, an oxalic acid, a chromic acid or a mixed acid thereof is used. The electrolyte concentration is appropriately determined according to the kind of the electrolyte.

The anodization treatment conditions vary depending on the electrolyte used and therefore, cannot be indiscriminately specified, but in general, the conditions are preferably such that the electrolyte concentration is from 1 to 80 mass%, the liquid temperature is from 5 to 70°C, the current density is from 5 to 60 A/dm², the voltage is from 1 to 100 V, and the electrolysis time is from 10 seconds to 5 minutes. The amount of the anodic oxide film formed is preferably from 1.0 to 5.0 g/m², more preferably from 1.5 to 4.0 g/m². Within this range, good press life and good scratch resistance in the non-image area of the lithographic printing plate can be obtained.

As for the support used in the invention, the substrate having thereon an anodic oxide film after the above-described surface treatment may be used as-is, but in order to more improve adhesion to the upper layer, hydrophilicity, antiscumming property, heat insulation and the like, treatments described in JP-A-2001-253181 and JP-A-2001-322365, such as treatment for enlarging micropores of the anodic oxide film, treatment for pore-sealing micropores and surface-hydrophilizing treatment of dipping the substrate in an aqueous solution containing a hydrophilic compound, may be appropriately selected and applied. Of course, the enlarging treatment and pore-sealing treatment are not limited to those described in these patent publications and any conventionally known method may be employed.

The pore-sealing treatment may be a pore-sealing treatment with steam, a pore-sealing treatment with fluorinated zirconic acid alone, a pore-sealing treatment with an aqueous solution containing an inorganic fluorine compound, such as treatment with sodium fluoride, a pore-sealing treatment with steam having added thereto lithium chloride, or a pore-sealing treatment with hot water.

In particular, a pore-sealing treatment with an aqueous solution containing an inorganic fluorine compound, a pore-sealing treatment with water vapor, and a pore-sealing treatment with hot water are preferred.

As for the hydrophilization treatment, an alkali metal silicate method described in U.S. Patents 2,714,066, 3,181,461, 3,280,734 and 3,902,734 is known. In this method, the support is dipped in an aqueous solution of sodium silicate or the like, or electrolyzed. Other examples include a method of treating the support with potassium fluorozirconate described in JP-B-36-22063, and a method of treating the support with polyvinylphosphonic acid described in U.S. Patents 3,276,868, 4,153,461 and 4,689,272.

In the case where a support insufficient in the hydrophilicity on the surface, such as polyester film, is used as the support of the present invention, a hydrophilic layer is preferably coated to render the surface hydrophilic. The hydrophilic layer is preferably a layer formed by coating a coating solution containing a colloid of an oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer having an organic hydrophilic matrix obtained by crosslinking or pseudo-crosslinking an organic hydrophilic polymer described in JP-A-2002-79772, a hydrophilic layer having an inorganic hydrophilic matrix obtained by sol-gel conversion comprising hydrolysis and condensation reaction of polyalkoxysilane, titanate, zirconate or aluminate, or a hydrophilic layer comprising an inorganic thin film having a surface containing a metal oxide. Among these, a hydrophilic layer formed by coating a coating solution containing a colloid of an oxide or hydroxide of silicon is more preferred.

In the case of using polyester film or the like as the support of the present invention, an antistatic layer is preferably provided on the hydrophilic layer side or opposite side of the support or on both sides. When an antistatic layer is provided between the support and the hydrophilic layer, this contributes to the enhancement of adhesion to the hydrophilic layer. Examples of the antistatic layer which can be used include a polymer layer having dispersed therein metal oxide fine particle or matting agent described in JP-A-2002-79772.

The support preferably has a center line average roughness of 0.10 to 1.2 µm. Within this range, good adhesion to the image recording layer, good press life and good antiscumming property can be obtained.

The color density of the support is preferably from 0.15 to 0.65 in terms of the reflection density value. Within this range, good image-forming property by virtue of antihalation at the image exposure and good suitability for plate inspection after development can be obtained.

### (Undercoat Layer)

In the lithographic printing plate precursor of the present invention, an undercoat layer comprising a compound having a polymerizable group is preferably provided on the support. When the undercoat layer is used, the image recording layer is provided on the undercoat layer. The undercoat layer has an effect of strengthening, in the exposed area, the adhesion between the support and the image recording layer and, in the unexposed part, facilitating the separation of image recording layer from the support, thereby enhancing the developability.

Specific suitable examples of the undercoat layer include a silane coupling agent having an addition-polymerizable ethylenic double bond reactive group described in JP-A-10-282679, and a phosphorus compound having an ethylenic double bond reactive group described in JP-A-2-304441. A particularly preferred compound is a compound having a polymerizable group such as methacryl group and allyl group, and a support-adsorbing group such as sulfonic acid group, phosphoric acid group and phosphoric acid ester. Also, a compound having a hydrophilicity-imparting group such as ethylene oxide group, in addition to the polymerizable group and the support-adsorbing group, can be suitably used.

The coated amount (solid content) of the undercoat layer is preferably from 0.1 to 100 mg/m², more preferably from 1 to 30 mg/m².

### (Protective Layer)

In the lithographic printing plate precursor of the present invention, a water-soluble protective layer may be provided on the image recording layer for the purpose of preventing generation of scratches or the like on the image recording layer, blocking oxygen or preventing ablation at the exposure with a high-intensity laser.

In the present invention, the exposure is usually performed in air and the protective layer prevents low molecular compounds such as oxygen and basic substance present in air, which inhibit a radical polymerization reaction occurring upon exposure in the image recording layer, from mixing into the image recording layer and thereby prevents the inhibition of image-forming reaction at the exposure in air. Accordingly, the property required of the protective layer is low permeability to low molecular compounds such as oxygen. Furthermore, the protective layer preferably has good transparency to light used for exposure, excellent adhesion to the image recording layer, and easy removability with an aqueous solution for simple development after exposure. Various studies have been heretofore made on the protective layer having these properties and such protective layers are described in detail, for example, in U.S. patent 3,458,311 and JP-B-55-49729.

Examples of the material used for the protective layer include water-soluble polymer compounds having relatively excellent crystallinity. Specific examples thereof include water-soluble polymers such as polyvinyl alcohol, polyvinylpyrrolidone, acidic celluloses, gelatin, gum arabic and polyacrylic acid. In particular, when polyvinyl alcohol (PVA) is used as the main component, most excellent results are obtained with respect to basic properties such as oxygen-blocking property and development removability. A part of the polyvinyl alcohol may be replaced by an ester, an ether or an acetal or may have another copolymerization component as long as the polyvinyl alcohol contains an unsubstituted vinyl alcohol unit for giving necessary oxygen-blocking property and water solubility to the protective layer.

Examples of the polyvinyl alcohol which can be suitably used include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 produced by Kuraray Co., Ltd.

The components (for example, selection of PVA and use of additives), coated amount and the like of the protective layer are appropriately selected by taking account of fogging, adhesion, scratch resistance and the like in addition to the oxygen-blocking property and development removability. Generally, as the PVA has a higher percentage of hydrolysis (namely, as the unsubstituted vinyl alcohol unit content in the protective layer is higher) or as the layer thickness is larger, the oxygen-blocking property is enhanced and this is preferred in view of sensitivity. Also, in order to prevent the generation of unnecessary polymerization reaction at the production or during storage or unnecessary fogging at the image exposure or prevent thickening or the like of the image line, excessively high oxygen permeability is not preferred. Accordingly, the oxygen permeability A at 25°C and 1 atm is preferably 0.2≤A≤20 (ml/m²·day).

As for other components of the protective layer, glycerin, dipropylene glycol or the like may be added in an amount corresponding to several mass% based on the (co)polymer so as to impart flexibility. Also, an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether may be added in an amount of several mass% based on the above-described water-soluble polymer compound.

The adhesion to the image area, scratch resistance and the like are also very important in view of handling of the lithographic printing plate precursor. More specifically, when a protective layer which is hydrophilic by containing a water-soluble polymer compound is stacked on the image recording layer which is lipophilic, the protective layer is readily separated due to insufficient adhesive strength and in the separated portion, defects such as curing failure ascribable to polymerization inhibition by oxygen may be caused.

In order to solve this problem, various proposals have been made with an attempt to improve the adhesive property between the image recording layer and the protective layer. For example, JP-A-49-70702 and Unexamined British Patent Publication No. 1,303,578 describe a technique of mixing from 20 to 60 mass% of an acrylic emulsion, a water-insoluble vinylpyrrolidone-vinyl acetate copolymer or the like in a hydrophilic polymer mainly comprising polyvinyl alcohol, and stacking the prepared solution on the image recording layer, thereby obtaining sufficiently high adhesive property. In the present invention, these known techniques all can be used.

Furthermore, other functions may be imparted to the protective layer. For example, when a colorant (for example, water-soluble dye) excellent in the transparency to infrared light used for exposure and capable of efficiently absorbing light at other wavelengths is added, the aptitude for safelight can be enhanced without causing decrease of sensitivity.

The thickness of the protective layer is suitably from 0.1 to 5 µm, preferably from 0.2 to 2 µm.

The method for coating the protective layer is described in detail, for example, in U. S. Patent 3,458,311 and JP-B-55-49729.

### (Backcoat Layer)

After the support is subjected to a surface treatment or the undercoat layer is formed, a backcoat may be provided on the back surface of the support, if desired.

Suitable examples of the backcoat include a coat layer comprising a metal oxide obtained by hydrolyzing and polycondensing an organic polymer compound described in JP-A-5-45885 or an organic or inorganic metal compound described in JP-A-6-35174. Among these, those using an alkoxy compound of silicon, such as Si(OCH₃)₄, Si(OC₂H₅)₄, Si(OC₃H₇)₄ and Si(OC₄H₉)₄, are preferred because the raw material is inexpensive and easily available.

### <Exposure>

In the plate-making method of the present invention, the lithographic printing plate precursor is imagewise exposed by the exposure through a transparent original having a line image, a halftone image or the like, or by the laser scan-exposure based on digital data. Examples of the light source for the exposure include a carbon arc lamp, a high-pressure mercury lamp, a xenon lamp, a metal halide lamp, a fluorescent lamp, a tungsten lamp, a halogen lamp, an ultraviolet ray laser, a visible ray laser and an infrared ray laser. In particular, a laser is preferred. Examples of the laser include a semiconductor laser of emitting light at 250 to 420 nm, and a solid or semiconductor laser of emitting infrared ray at 760 to 1,200 nm. In the case of using a laser, the imagewise scan-exposure is preferably performed according to digital data. Also, in order to shorten the exposure time, a multibeam laser device is preferably used.

### [Examples]

The present invention is described in greater detail below by referring to the Examples, but the present invention should not be construed as being limited thereto.

### Preparation of Support:

A 0.3 mm-thick aluminum plate (construction material: 1050) was degreased with an aqueous 10 mass% sodium aluminate solution at 50°C for 30 seconds to remove the rolling oil on the surface. Thereafter, the aluminum plate surface was grained by using three nylon brushes implanted with bundled bristles having a diameter of 0.3 mm and a water suspension (specific gravity: 1.1 g/cm³) of pumice having a median diameter of 25 µm, and then thoroughly washed with water. This plate was etched by dipping it in an aqueous 25 mass% sodium hydroxide solution at 45°C for 9 seconds and after washing with water, dipped in 20 mass% nitric acid at 60°C for 20 seconds, followed by washing with water. At this time, the etched amount of the grained surface was about 3 g/m².

Subsequently, the aluminum plate was subjected to a continuous electrochemical surface-roughening treatment by using AC voltage at 60 Hz. The electrolytic solution used here was an aqueous 1 mass% nitric acid solution (containing 0.5 mass% of aluminum ion) at a liquid temperature of 50°C. This electrochemical surface-roughening treatment was performed by using an AC power source of giving a rectangular AC having a trapezoidal waveform such that the time TP necessary for the current value to reach the peak from zero was 0.8 msec and the duty ratio was 1:1, and disposing a carbon electrode as the counter electrode. The auxiliary anode was ferrite. The current density was 30 A/dm² in terms of the peak value of current, and 5% of the current flowing from the power source was split to the auxiliary anode. The quantity of electricity at the nitric acid electrolysis was 175 C/dm² when the aluminum plate was serving as the anode. Thereafter, the aluminum plate was water-washed by spraying.

Thereafter, the aluminum plate was subjected to an electrochemical surface-roughening treatment in the same manner as in the nitric acid electrolysis above by using, as the electrolytic solution, an aqueous 0.5 mass% hydrochloric acid solution (containing 0.5 mass% of aluminum ion) at a liquid temperature of 50°C under the conditions that the quantity of electricity was 50 C/dm² when the aluminum plate was serving as the anode, and then water-washed by spraying. This plate was treated in 15 mass% sulfuric acid (containing 0.5 mass% of aluminum ion) as the electrolytic solution at a current density of 15 A/dm² to provide a DC anodic oxide film of 2.5 g/m², then washed with water and dried. The center line average roughness (Ra) of this substrate was measured by using a needle having a diameter of 2 µm and found to be 0.51 µm.

On the thus-treated aluminum plate, the following Undercoat Solution (I) was coated to have a dry coated amount of 10 mg/m². In this way, a support for use in the tests later was produced.

### Undercoat Solution (1):

| | |
|---|---|
| Undercoat Compound (1) shown below | 0.017 g |
| Methanol | 9.00 g |
| Water | 1.00 g |

### Undercoat Compound (1):

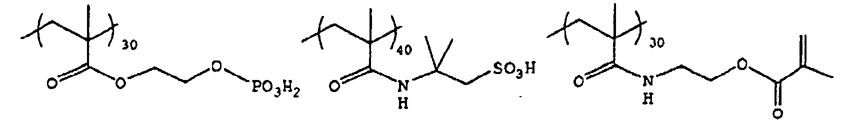

### Production of Lithographic Printing Plate Precursor A:

On the support with the undercoat layer above, Coating Solution (1) for Image Recording Layer was bar-coated and dried in an oven at 100°C for 75 seconds to form an image recording layer having a dry coated amount of 1.0 g/m², and a coating solution for protective layer having the following composition was further coated thereon by using a bar to give a coated amount of 1.0 g/m² when dried in an oven at 100°C for 90 seconds, thereby obtaining Lithographic Printing Plate Precursor A.

Coating Solution (1) for Image Recording Layer was obtained by mixing and stirring Photosensitive Solution (1) and Microcapsule Solution (1) shown below immediately before coating.

### Photosensitive Solution (1):

| | |
|---|---|
| Binder Polymer (1) | 0.162 g |
| Polymerization Initiator (1) shown below | 0.100 g |
| Infrared Absorbent (1) shown below | 0.020 g |
| Polymerizable compound (Aronics M-215, produced by Toa Gosei Co., Ltd.) | 0.385 g |
| Fluorine-Containing Surfactant (1) shown below | 0.044 g |
| Methyl ethyl ketone | 1.091 g |
| 1-Methoxy-2-propanol | 8.609 g |

### Microcapsule Solution (1):

| | |
|---|---|
| Microcapsule (1) synthesized as follows | 2.640 g |
| Water | 2.425 g |

### Binder Polymer (1):

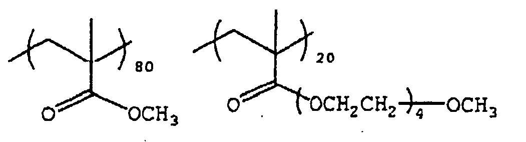

### Polymerization Initiator (1):

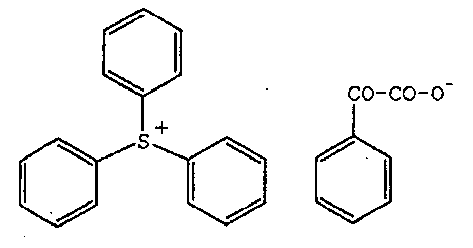

### Infrared Absorbent (1):

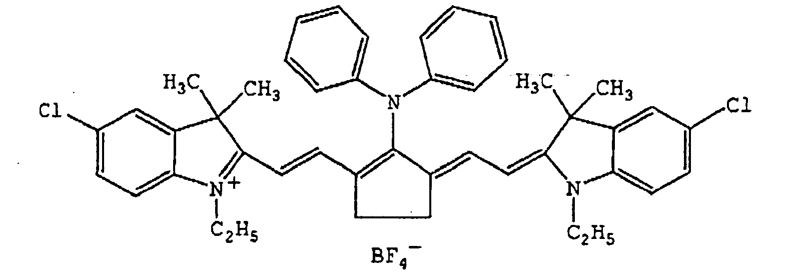

### Fluorine-Containing Surfactant (1):

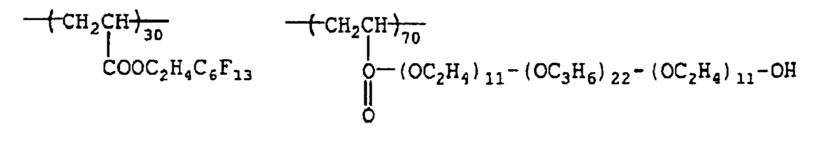

### (Synthesis of Microcapsule (1))

As the oil phase component, 10 g of trimethylolpropane and xylene diisocyanate adduct (Takenate D-110N, produced by Mitsui Takeda Chemicals, Inc., a 75% ethyl acetate solution), 6.00 g of Aronics M-215 (produced by Toa Gosei Co., Ltd.) and 0.12 g of Pionin A-41C (produced by Takemoto Oil & Fat Co., Ltd.) were dissolved in 16.67 g of ethyl acetate. As the aqueous phase component, 37.5 g of an aqueous 4 mass% PVA-205 solution was prepared. The oil phase component and the aqueous phase component were mixed and emulsified in a homogenizer at 12,000 rpm for 10 minutes. The resulting emulsified product was added to 25 g of distilled water and the mixture was stirred at room temperature for 30 minutes and then stirred at 40°C for 2 hours. The thus-obtained microcapsule solution was diluted with distilled water to a solid content concentration of 15 mass%. The average particle size was 0.2 µm.

### Coating Solution for Protective Layer:

| | |
|---|---|
| Water | 88 g |
| Polyvinyl alcohol PVA105 (produced by Kuraray Co., Ltd.) | 10 g |
| Polyethylene glycol (molecular weight: 2,000) | 2 g |
| Surfactant shown below | 1 g |

### Surfactant:

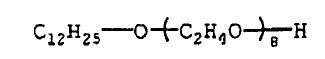

### (Production of Lithographic Printing Plate Precursor B)

Coating Solution (3) for Image Recording Layer having the following composition was bar-coated on Support (A) produced above and dried in an oven at 100°C for 60 seconds to form an image recording layer having a dry coated amount of 1.4 g/m², and Coating Solution (1) for Protective Layer was coated thereon to have a dry coated mass of 0.5 g/m² and dried at 120°C for 1 minute, thereby obtaining Lithographic Printing Plate Precursor B.

### Coating Solution (3) for Image Recording Layer:

| | |
|---|---|
| Binder Polymer (1) | 2.0 g |
| Polymerizable compound: | 1.5 g |
| isocyanuric acid EO-modified triacrylate (Aronics M-315, produced by Toa Gosei Co., Ltd.) | |
| Compound (1) shown below | 0.15 g |
| Compound (2) shown below | 0.20 g |
| Compound (3) shown below | 0.4 g |
| Ethyl Violet | 0.1 g |
| Thermopolymerization inhibitor | 0.1 g |
| N-nitrosophenylhydroxylamine aluminum salt | |
| Water-Soluble Fluorine-Containing Surfactant (1) | 0.02 g |
| Tetraethylamine hydrochloride | 0.06 g |
| 1-Methoxy-2-propanol | 17.5 g |
| Methyl ethyl ketone | 19.0 g |

(1) 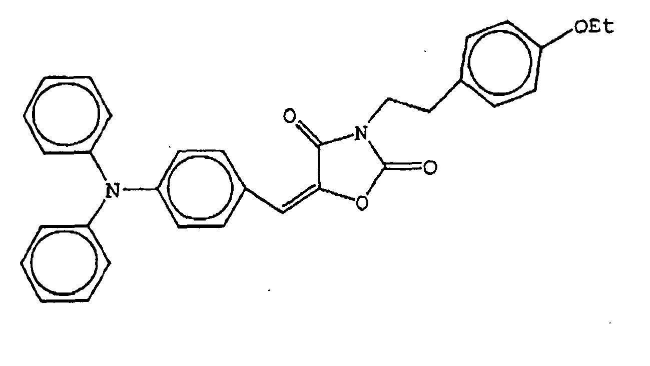
(2) 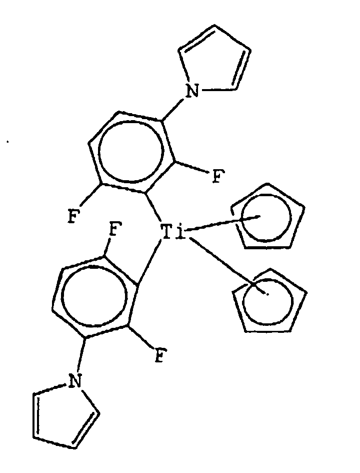
(3)

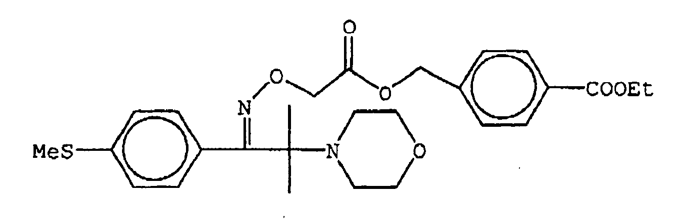

### Production of Processing Solution:

Processing Solutions I to 20 each having the composition shown in Table I below were produced. In the Table, the unit is [g].

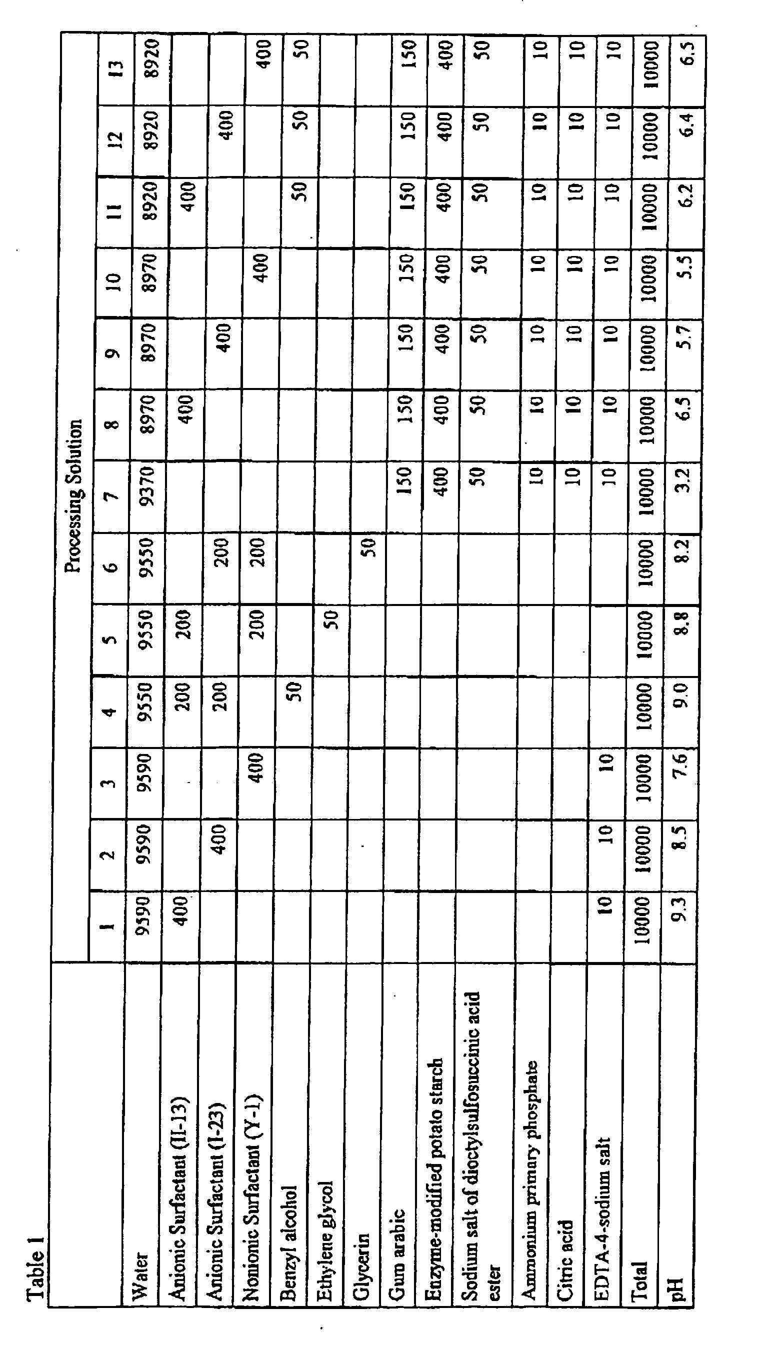

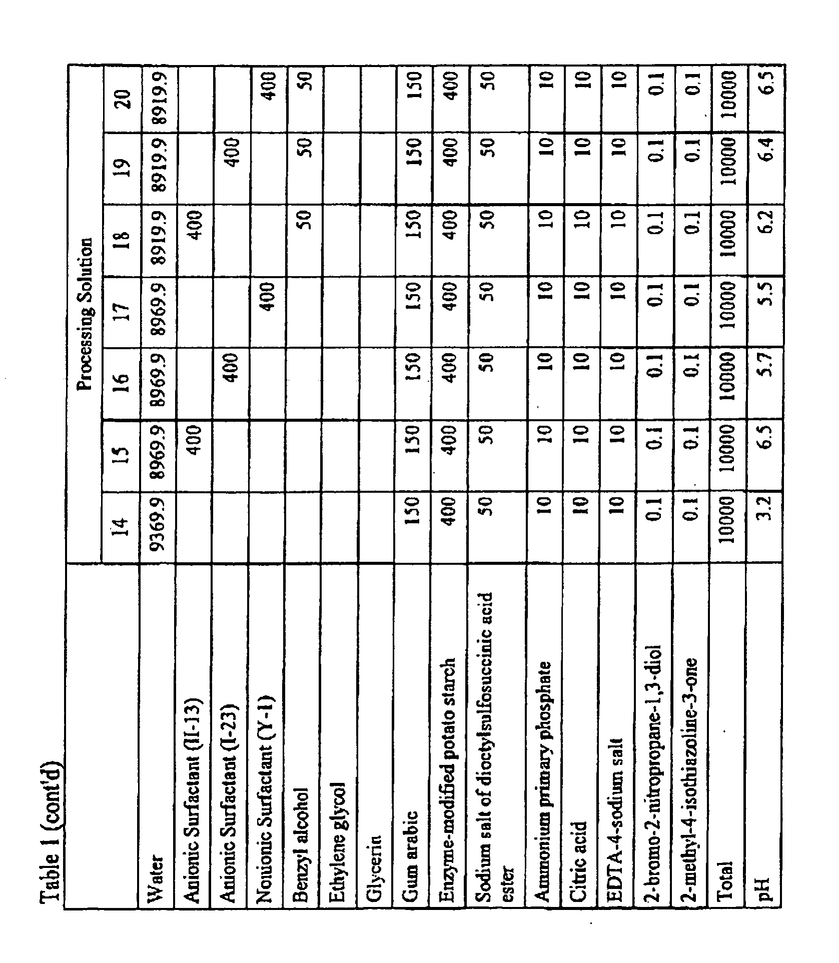

### 2. Evaluation of Plate (Evaluation of Developability)

Lithographic Printing Plate Precursor A obtained was imagewise exposed by using Trendsetter 3244VX (manufactured by Creo) on which a water-cooling 40 W infrared semiconductor laser was mounted, under the conditions that the output was 9 W, the rotation number of outer drum was 210 rpm and the resolution was 2,400 dpi.

Lithographic Printing Plate Precursor B was imagewise exposed by using a semiconductor laser of 405 nm with an output of 30 mW, under the conditions that the energy density was 0.5 mJ/cm² and the resolution was 2,400 dpi.

Subsequently, the processing was performed by using a processor shown in Fig. 1 under the conditions that the liquid temperature of the processing solution in the development tank 106 was 25°C. In the Figure, 108 is a transportation roller of which transit time from the inlet to the outlet was set to 15 seconds, and 112 is a rotary brush which was rotated at a rate of 280 mm/sec in the forward direction with respect to the transportation direction. The lithographic printing plate precursor discharged from the development tank was dried by natural drying. The lithographic printing plate precursor processed with Processing Solutions 1 to 6 was then re-processed with Processing Solution 7, and the lithographic printing plate precursor processed with each of Processing Solutions 8 to 20 was then dried.

The sample which could be developed was rated ○, and the sample which could not be developed was rated ×.

### Printing:

The naturally dried lithographic printing plate precursor was loaded on a cylinder of Printing Press SOR-M manufactured by Heidelberg. Using a fountain solution (EU-3 (etching solution, produced by Fuji Photo Film Co., Ltd.))/water/ isopropyl alcohol = 1/89/10 (by volume)) and TRANS-G(N) black ink (produced by Dai-Nippon Ink & Chemicals, Inc.), 500 sheets were printed after supplying the fountain solution and ink at a printing speed of 6,000 sheets per hour.

The sample which did not cause staining was rated ○, and the sample which caused staining was rated ×.

The results are shown in Table 2.

**Table 2**

| | Lithographic Printing Plate | Processing Solution | Developability of Unexposed Area | Staining of Non-Image Area at Printing |
|---|---|---|---|---|
| Example 1 | A | 1, 7 | ○ | ○ |
| Example 2 | A | 2, 7 | ○ | ○ |
| Example 3 | A | 3, 7 | ○ | ○ |
| Example 4 | A | 4, 7 | ○ | ○ |
| Example 5 | A | 5, 7 | ○ | ○ |
| Example 6 | A | 6, 7 | ○ | ○ |
| Example 7 | A | 8 | ○ | ○ |
| Example 8 | A | 9 | ○ | ○ |
| Example 9 | A | 10 | ○ | ○ |
| Example 10 | A | 11 | ○ | ○ |
| Example 11 | A | 12 | ○ | ○ |
| Example 12 | A | 13 | ○ | ○ |
| Example 13 | B | 1, 7 | ○ | ○ |
| Example 14 | B | 2, 7 | ○ | ○ |
| Example 15 | B | 3, 7 | ○ | ○ |
| Example 16 | B | 4, 7 | ○ | ○ |
| Example 17 | B | 5, 7 | ○ | ○ |
| Example 18 | B | 6, 7 | ○ | ○ |
| Example 19 | B | 8 | ○ | ○ |
| Example 20 | B | 9 | ○ | ○ |
| Example 21 | B | 10 | ○ | ○ |
| Example 22 | B | 11 | ○ | ○ |
| Example 23 | B | 12 | ○ | ○ |
| Example 24 | B | 13 | ○ | ○ |
| Example 25 | A | 15 | ○ | ○ |
| Example 26 | A | 16 | ○ | ○ |
| Example 27 | A | 17 | ○ | ○ |
| Example 28 | A | 18 | ○ | ○ |
| Example 29 | A | 19 | ○ | ○ |
| Example 30 | A | 20 | ○ | ○ |
| Example 31 | B | 15 | ○ | ○ |
| Example 32 | B | 16 | ○ | ○ |
| Example 33 | B | 17 | ○ | ○ |
| Example 34 | B | 18 | ○ | ○ |
| Example 35 | B | 19 | ○ | ○ |
| Example 36 | B | 20 | ○ | ○ |
| | | | | |
| Comparative Example 1 | B | 1 | ○ | × |
| Comparative Example 2 | B | water | × | × |

As seen from the results above, Examples 1 to 36 of the present invention are clearly excellent in the developability and antiscumming property as compared with Comparative Examples.

According to the present invention, a printing plate having a constant quality can be produced with use of a developer free from deterioration due to carbonic acid gas and keeping a constant developing property at all times. Furthermore, a production method of a lithographic printing plate, which realizes reduction in the replenishing amount of developer and the amount of waste solution, is advantageous in view of running cost and environmental concern, and ensures excellent antiscumming property, can be provided.

## Claims

1. A plate-making method of a lithographic printing plate, comprising:
imagewise exposing a lithographic printing plate precursor comprising a support and an image recording layer on or above the support, so as to cure an exposed area of the image recording layer; and
developing the exposed lithographic printing plate precursor with an aqueous solution containing a water-soluble polymer compound and 1 mass% or more of either one or both of a nonionic surfactant and an anionic surfactant, the aqueous solution having a pH of 2 to 10, wherein the image recording layer comprises (1) a polymerization initiator, (2) a polymerizable compound and (3) a hydrophobic binder polymer.

2. A plate-making method of a lithographic printing plate, comprising:
imagewise exposing a lithographic printing plate precursor comprising a support and an image recording layer on or above the support, so as to cure an exposed area of the image recording layer;
developing the exposed lithographic printing plate precursor with an aqueous solution containing 1 mass% or more of either one or both of a nonionic surfactant and an anionic surfactant, the aqueous solution having a pH of 2 to 10; and
contacting the developed lithographic printing precursor with an aqueous solution containing a water-soluble polymer compound, wherein the image recording layer comprises (1) a polymerization initiator, (2) a polymerizable compound and (3) a hydrophobic binder polymer.

3. The plate-making method of a lithographic printing plate as claimed in claim 1 or 2,
wherein the anionic surfactant comprises a sulfonate anion group or a sulfuric monoester anion group and comprises at least one aromatic group which may have a substituent.

4. The plate-making method of a lithographic printing plate as claimed in claim 1 or 2, wherein the nonionic surfactant is at least one surfactant selected from the group consisting of nonionic aromatic ether-based surfactants represented by formula (1):
X-Y-O-(A)ₙ-(B)ₘ-H (1)
(wherein X represents an aromatic group which may have a substituent, Y represents a single bond or an alkylene group having from 1 to 10 carbon atoms, A and B are different from each other and each represents either -CH₂CH₂O- or -CH₂CH(CH₃)O-, n and m each represents 0 or an integer of 1 to 100, provided that n and m are not 0 at the same time and that when either n or m is 0, n and m are not 1).

5. The plate-making method of a lithographic printing plate as claimed in any one of claims 1 to 4,
wherein the lithographic printing plate precursor further comprises a protective layer on or above the image recording layer.

6. The plate-making method of a lithographic printing plate as claimed in any one of claims 1 to 5,
wherein said imagewise exposure is performed by using a laser of emitting light at 760 to 1,200 nm.

7. The plate-making method of a lithographic printing plate as claimed in any one of claims 1 to 5, wherein said imagewise exposure is performed by using a laser of emitting light at 250 to 420 nm.

8. The plate-making method of a lithographic printing plate as claimed in any one of claims 1 to 7,
wherein components of said image recording layer are partially or entirely enclosed in a microcapsule.

## Patentansprüche

1. Plattenherstellungsverfahren für eine Lithographie-Druckplatte, das folgendes umfaßt:
die bildweise Belichtung eines Lithographie-Druckplattenvorläufers, der einen Träger und eine Bildaufzeichnungsschicht auf oder über dem Träger umfaßt, um einen belichteten Bereich der Bildaufzeichnungsschicht auszuhärten, und
Entwickeln des belichteten Lithographie-Druckplattenvorläufers mit einer wäßrigen Lösung, die eine wasserlösliche Polymerverbindung und 1 Massen% oder mehr von entweder einem oder beiden von einem nichtionischen Tensid und einem anionischen Tensid enthält, wobei die wäßrige Lösung einen pH von 2 bis 10 hat,
wobei die Bildaufzeichnungsschicht (1) einen Polymerisationsstarter, (2) eine polymerisierbare Verbindung und (3) ein hydrophobes Binderpolymer umfaßt.

2. Plattenherstellungsverfahren für eine Lithographie-Druckplatte, das folgendes umfaßt:
das bildweise Belichten eines Lithographie-Druckplattenvorläufers, der einen Träger und eine Bildaufzeichnungsschicht auf oder über dem Träger umfaßt, um so einen belichteten Bereich der Bildaufzeichnungsschicht auszuhärten,
Entwickeln des belichteten Lithographie-Druckplattenvorläufers mit einer wäßrigen Lösung, die 1 Massen% oder mehr von einem oder beiden von einem nichtionischen Tensid und einem anionischen Tensid enthält, wobei die wäßrige Lösung einen pH von 2 bis 10 hat, und
Inkontaktbringen des entwickelten Lithographie-Druck[platten]vorläufers mit einer wäßrigen Lösung, die eine wasserlösliche Polymerverbindung enthält,
wobei die Bildaufzeichnungsschicht (1) einen Polymerisationsstarter, (2) eine polymerisierbare Verbindung und (3) ein hydrophobes Binderpolymer umfaßt..

3. Plattenherstellungsverfahren für eine Lithographie-Druckplatte wie in Anspruch 1 oder 2 beansprucht, bei dem das anionische Tensid eine Sulfonatanion-Gruppe oder eine Schwefelsäuremonoesteranion-Gruppe umfaßt und mindestens eine aromatische Gruppe umfaßt, die einen Substituenten haben kann.

4. Plattenherstellungsverfahren für eine Lithographie-Druckplatte wie in Anspruch 1 oder 2 beansprucht, bei dem das nichtionische Tensid mindestens ein Tensid ist, ausgewählt aus der Gruppe bestehend aus nichtionischen Tensiden auf aromatischer Etherbasis, wiedergegeben durch Formel (1):
X-Y-O-(A)ₙ-(B)ₘ-H (1)
(worin X eine aromatische Gruppe bezeichnet, die einen Substituenten haben kann, Y eine Einfachbindung oder eine Alkylengruppe mit 1 bis 10 Kohlenstoffatomen bezeichnet, A und B sich voneinander unterscheiden und jeweils entweder -CH₂CH₂O- oder -CH₂CH(CH₃)O- bedeuten, n und m jeweils 0 oder eine ganze Zahl von 1 bis 100 bezeichnen, mit der Maßgabe, daß n und m nicht gleichzeitig 0 sind und daß dann, wenn eines von n oder m 0 ist, n und m nicht 1 sind).

5. Plattenherstellungsverfahren für eine Lithographie-Druckplatte wie in mindestens einem der Ansprüche 1 bis 4 beansprucht, bei dem der Lithographie-Druckplattenvorläufer ferner eine Schutzschicht auf oder über der Bildaufzeichnungsschicht umfaßt.

6. Plattenherstellungsverfahren für eine Lithographie-Druckplatte wie in mindestens einem der Ansprüche 1 bis 5 beansprucht, bei dem die bildweise Belichtung unter Verwendung eines Lasers mit emittiertem Licht bei 760 bis 1.200 nm durchgeführt wird

7. Plattenherstellungsverfahren für eine Lithographie-Druckplatte wie in mindestens einem der Ansprüche 1 bis 5 beansprucht, bei dem die bildweise Belichtung unter Verwendung eines Lasers mit emittiertem Licht bei 250 bis 420 nm durchgeführt wird

8. Plattenherstellungsverfahren für eine Lithographie-Druckplatte wie in mindestens einem der Ansprüche 1 bis 7 beansprucht, bei dem Komponenten der Bildaufzeichnungsschicht teilweise oder vollständig in einer Mikrokapsel eingeschlossen sind.

## Revendications

1. Procédé de fabrication d'une plaque d'impression lithographique, comprenant:
exposer, conformément à une image, un précurseur de plaque d'impression lithographique comprenant un support et une couche d'enregistrement d'image sur ou au-dessus du support, de sorte à durcir une zone exposée de la couche d'enregistrement d'image ; et
développer le précurseur de plaque d'impression lithographique exposé avec une solution aqueuse contenant un composé polymère soluble dans l'eau et 1 % en masse ou plus d'un agent tensioactif non ionique et/ou un agent tensioactif anionique, la solution aqueuse ayant un pH de 2 à 10, dans lequel la couche d'enregistrement d'image comprend : (1) un initiateur de polymérisation, (2) un composé polymérisable et (3) un polymère liant hydrophobe.

2. Procédé de fabrication d'une plaque d'impression lithographique, comprenant:
exposer, conformément à une image, un précurseur de plaque d'impression lithographique comprenant un support et une couche d'enregistrement d'image sur ou au-dessus du support, de sorte à durcir une zone exposée de la couche d'enregistrement d'image ;
développer le précurseur de plaque d'impression lithographique exposé avec une solution aqueuse contenant 1 % en masse ou plus d'un agent tensioactif non ionique et/ou un agent tensioactif anionique, la solution aqueuse ayant un pH de 2 à 10 ; et
mettre en contact le précurseur d'impression lithographique développé avec une solution aqueuse contenant un composé polymère soluble dans l'eau, dans lequel la couche d'enregistrement d'image comprend : (1) un initiateur de polymérisation, (2) un composé polymérisable et (3) un polymère liant hydrophobe.

3. Procédé de fabrication d'une plaque d'impression lithographique selon la revendication 1 ou 2,
dans lequel l'agent tensioactif anionique comprend un groupe anion sulfonate ou un groupe anion sulfurique monoester et comprend au moins un groupe aromatique qui peut avoir un substituant.

4. Procédé de fabrication d'une plaque d'impression lithographique selon la revendication 1 ou 2, dans lequel l'agent tensioactif non ionique est au moins un agent tensioactif sélectioné dans le groupe constitué par les agents tensioactifs non ioniques à base d'éther aromatique représentés par la formule (1) :
X-Y-O-(A)ₙ-(B)ₘ-H (1)
(dans laquelle X représente un groupe aromatique qui peut avoir un substituant, Y représente une liaison simple ou un groupe alkylène ayant de 1 à 10 atomes de carbone, A et B sont différents et chacun représente -CH₂CH₂O- ou -CH₂CH(CH₃)O-, n et m représente chacun 0 ou un entier de 1 à 100, à condition que n et m ne valent pas 0 en même temps et que, lorsque n ou m vaut 0, n et m ne valent pas 1).

5. Procédé de fabrication d'une plaque d'impression lithographique selon l'une quelconque des revendications 1 à 4,
dans lequel le précurseur de plaque d'impression lithographique comprend en outre une couche protectrice sur ou au-dessus de la couche d'enregistrement d'image.

6. Procédé de fabrication d'une plaque d'impression lithographique selon l'une quelconque des revendications 1 à 5,
dans lequel ladite exposition conformément à une image est réalisée en utilisant un laser émettant de la lumière entre 760 et 1 200 nm.

7. Procédé de fabrication d'une plaque d'impression lithographique selon l'une quelconque des revendications 1 à 5,
dans lequel ladite exposition conformément à une image est réalisée en utilisant un laser émettant de la lumière entre 250 et 420 nm.

8. Procédé de fabrication d'une plaque d'impression lithographique selon l'une quelconque des revendications 1 à 7,
dans lequel les composants de ladite couche d'enregistrement d'image sont partiellement ou entièrement inclus dans une microcapsule.
